# EUROPEAN PATENT APPLICATION

(11) **EP 0 702 271 A1**
(43) Date of publication of application: **20.03.1996**
(21) Application number: 95113932.8
(22) Date of filing: 05.09.1995
(51) Int. Cl.: G03F 7/039

(54) **Positive working printing plate**

(30) Priority: 06.09.1994 JP 212947/94
(71) Applicant: FUJI PHOTO FILM CO., LTD., Kanagawa 250-01 (JP)
(72) Inventor: Kondo, Syunichi, c/o Fuji Photo Film Co., Ltd., Haibara-gun, Shizuoka (JP); Tsuchiya, Mitsumasa, c/o Fuji Photo Film Co., Ltd., Haibara-gun, Shizuoka (JP); Sato, Hiroki, c/o Fuji Photo Film Co., Ltd., Haibara-gun, Shizuoka (JP)
(74) Representative: Grünecker, August, Dipl.-Ing.

(57) **Abstract**

There is provided a positive working printing plate comprising an aluminum support coated with a positive working photosensitive composition which comprises (a) a compound containing at least two enol ether groups, (b) a linear high polymer having a specified monomer composition and containing both acid groups and hydroxyl groups and (c) a compound capable of producing an acid through decomposition upon irradiation with active rays or radiation and in which the component (a) and the component (b) are cross-linked by applied heat.

## Description

### FIELD OF THE INVENTION

The present invention relates to a positive working printing plate composition and, more particularly, to a positive working plate which can ensure slight scumming and high impression performance.

### BACKGROUND OF THE INVENTION

In the field of lithographic printing plates and the like, orthoquinone diazide compounds have so far been known as a material capable of acquiring solubility through irradiation with active rays, or the so-called positively working photosensitive material. Actually, those compounds have been enjoyed a prevailing use in lithographic printing plates and so on. Such orthoquinone diazide compounds are disclosed, e.g., in U.S. Patents 2,766,118, 2,767,092, 2,772,972, 2,859,112, 2,907,655, 3,046,110, 3,046,111, 3,046,115, 3,046,118, 3,046,119, 3,046,120, 3,046,121, 3,046,122, 3,046,123, 3,061,430, 3,102,809, 3,106,465, 3,635,709 and 3,647,443, and further described in a great number of publications.

The utilization of those orthoquinone diazide compounds are due to their property of causing decomposition by irradiation with active rays to produce a 5-membered cyclic carboxylic acid, thereby becoming soluble in alkali. However, none of them showed satisfactory sensitivity. This is because it is difficult to photochemically sensitize orthoquinone diazide compounds and their quantum efficiency is intrinsically less than 1.

In general, those compounds utilized lithographic printing plates and the like are exposed to light via patterns by means of a printer or the like, and the exposed parts thereof are removed with an alkaline developer or a solvent, thereby making plates. Such printing plates tend to undergo influences of developer or solvent concentration and temperature and a developing time, and so they have a drawback that they cannot ensure consistent sensitivity (namely, they have narrow development latitude). In addition, since such compounds have their sensitivities in a fixed wavelength region, their light source suitability is poor and it is difficult to impart white lamplight safety to them. Further, they have strong absorption in the so-called Deep UV region, so they are unsuitable for the use with the intention of heightening the resolving power of photoresist by taking advantage of light of short wavelengths.

For the purpose of overcoming the aforesaid difficulties, there have been attempted the methods disclosed, e.g., in JP-B-48-12242 (the term "JP-B" as used herein means an "examined Japanese patent publication), JP-A-52-40125 (the term "JP-A" as used herein means an "unexamined published Japanese patent application") and U.S. Patent 4,307,173. However, all the improvements brought about by such methods are still insufficient.

In recent years, there have been made some proposals for development of novel positive working photosensitive materials to replace orthoquinone diazide compounds. For instance, the polymer compounds which contain orthocarbinol ester groups were proposed in JP-B-56-2696. However, such polymers also failed in securing sufficient sensitivity.

As other positive working photosensitive materials which can replace conventional quinone diazides, there have recently been proposed the compositions comprising a compound capable of producing acids by light, a compound capable of changing their solubilities in an alkaline water through hydrolysis or so on with the acids and, if necessary, a binder resins. More specifically, instanced are the positive image formation methods in which by acids produced upon exposure to light are decomposed the specified low or high molecular weight acetals, O,N-acetals containing aromatic compounds as hydroxyl or amine component (U.S. Patent 3,779,778), and ortho esters and amidoacetals (West German Patent Application OLS No. 2,610,842). In addition, similar methods for positive image formation are described in JP-A-64-33546, JP-A-48-89003, JP-A-51-120714, JP-A-53-133429, JP-A-55-126236, JP-A-53-133428, JP-A-55-12995, JP-A-57-31674, JP-A-57-31675, JP-A-57-37347, JP-A-62-215947, JP-A-1-106040 and JP-A-1-106041.

However, those compositions are all low in sensitivity, or they are small in solubility difference between the unexposed area and the exposed area, or positive images formed therefrom have a pattern shape problem. Practically, therefore, they are not put into practice yet.

On the other hand, it is described in JP-A-62-45971 that a positive image can be formed using an enol ether group-containing compound as acid decomposable compound and according to the similar method to the above. Further, JP-A-4-215661 discloses that a positive image can be formed by producing a polymer having an acetal structure through the reaction of a monofunctional vinyl ether compound with the carboxylic acid present in a binder resin and adopting the method similar to the above. In these cases also, the sensitivity obtained is low and the solubility difference between the unexposed area and the exposed area is small. Only under limited conditions, such methods are successful in formation of clear positive images.

As a result of our various examinations for solving the above-described problems, it was found that a positive working photosensitive composition comprising (a) a compound containing at least two enol ether groups represented by the following formula, (b) a linear high polymer containing acidic groups and hydroxyl groups and (c) a compound capable of producing an acid by being decomposed upon irradiation with active rays or radiation, wherein component (a) and component (b) were cross-linked by applied heat, had high sensitivity to ultraviolet rays, visible rays, electron beams or X-rays, and enabled the formation of clear positive images under diverse development conditions (JP-A-6-230574):

(Q²)(Q¹)C = C(Q³)―O―

wherein Q¹, Q² and Q³ are the same or different, and each represents a hydrogen atom, an alkyl group or an aryl group, and two of them may combine to form a saturated or olefinically unsaturated ring.

However, it has turned out that the lithographic printing plate obtained by coating and drying the above-described positive working photosensitive composition on an aluminum support to which hydrophilicity is previously imparted by a silicate treatment was subject to frequent generation of scum even at the initial stage of printing operation and an extent of the scumming was increased by a continuance of the printing operation. With the intention of reducing the scum, it has been tried to control the developing time and the development temperature, and to provide the aluminum support with an undercoat of triethanolamine hydrochloride, β-alanine or the like. However, the reduction in scum made by adopting such measures is not enough to allow the practical use of the resulting printing plates.

### SUMMARY OF THE INVENTION

An object of the present invention is therefore to provide a positive working printing plate composition which has high sensitivity and enables the printing plate to be used in a wide wavelength range.

Another object of the present invention is to provide a positive working printing plate which has a large solubility difference between unexposed and exposed areas and a wide development latitude.

A still another object of the present invention is to provide a positive working printing plate which ensures slight scum and high impression performance.

For the purpose of achieving the above-described objects, we have made intensive studies on the thermally cross-linked positive working printing plate composition which comprises a combination of a compound containing at least two enol ether groups, which has high sensitivity and wide development latitude, a linear high polymer containing acidic and hydroxyl groups and a compound capable of generating an acid by being decomposed upon exposure to active rays or radiations (which is called a photo-acid generator, hereinafter), and which is coated on an aluminum support to which hydrophilicity is previously imparted by a silicate treatment. As a result, we have ascertained that the scumming at issue was mainly due to the linear high polymer remaining on the silicate-treated hydrophilic support surface through the reaction induced between the hydroxyl groups of the linear high polymer and the silicate on the aluminum support during coating and drying operations or with a lapse of time.

In order to take effective measures to solve the aforesaid problem, linear high polymers having various compositions have been examined. Thus, it has been found out that the scumming can be sharply reduced when the content of acidic groups and that of hydroxyl groups in a linear high polymer are in specified ranges respectively, thereby achieving the present invention.

That is, the foregoing objects of the present invention are attained with a positive working printing plate comprising an aluminum support, to which hydrophilicity is previously imparted by a silicate treatment, having provided thereon a positive working photosensitive composition containing at least (a) a compound having at least two enol ether groups represented by formula (I), (b) a linear high polymer containing acid groups and hydroxy groups and (c) a compound capable of producing an acid by being decomposed upon irradiation with active rays or radiation, wherein the compound of component (a) and the linear high polymer of component (b) are cross-linked by applied heat, the linear high polymer of component (b) is a copolymer constituted of monomers containing acid group(s), monomers containing hydroxy group(s) and monomers containing neither acid nor hydroxy group or a copolymer constituted of monomers containing both acid and hydroxy groups and monomers containing neither acid nor hydroxy group, and the ratio of the monomers containing acid group(s) to the monomers containing hydroxy group(s) to the monomers containing neither acid nor hydroxy group is in the range of (5-30)/(5-30)/(90-40) by mole or the ratio of the monomers containing both acid and hydroxy groups to the monomers containing neither acid nor hydroxy group is in the range of (5-30)/(95-70) by mole:

(R²)(R¹)C = C(R³) - O - (I)

wherein R¹, R² and R³ are the same or different, and each represents a hydrogen atom, an alkyl group or an aryl group, and two of them may combine to form a saturated or olefinically unsaturated ring.

### DETAILED DESCRIPTION OF THE INVENTION

The positive working printing plate of the present invention comprises a silicate-treated hydrophilic aluminum support coated with a positive working photosensitive composition containing at least three components (a), (b) and (c) as described above, in which cross-linking structure is thermally formed between the enol ether group-containing compound of component (a) and the linear high polymer of component (b).

Firstly, the enol ether group-containing compound of component (a) is described in detail below.

The alkyl group for R¹, R² or R³ is generally an alkyl group containing 6 to 20 carbon atoms, and may be substituted with an alkyl group (preferably those having 1 to 20 carbon atoms), an alkoxy group (preferably those having 1 to 20 carbon atoms), an aryloxy group (preferably those having 6 to 20 carbon atoms), an acyl group (preferably those having 1 to 20 carbon atoms), an acyloxy group (preferably those having 1 to 20 carbon atoms), an alkylmercapto group (preferably those having 1 to 20 carbon atoms), an aminoacyl group (preferably those having 1 to 20 carbon atoms), a carboalkoxy group (preferably those having 1 to 20 carbon atoms), a nitro group, a sulfonyl group, a cyano group or a halogen atom.

The alkyl group for R¹, R² or R³ is preferably a saturated or unsaturated, straight-chain, branched or alicyclic, alkyl group having 1 to 20 carbon atoms and may be substituted with a halogen atom, a cyano group, an ester group, a hydroxy group, an alkoxy group (preferably those having 1 to 20 carbon atoms), an aryloxy group (preferably those having 6 to 20 carbon atoms) or an aryl group (preferably those having 6 to 20 carbon atoms).

Where any two among R¹, R² and R³ are combined with each other to form a cycloalkyl or cycloalkenyl group, the ring formed is generally a 3- to 8-membered one, preferably a 5- or 6-membered one.

Of enol ether groups represented by formula (I), the enol ether group in which at least one among R¹, R² and R³ is a methyl group or an ethyl group and the remainder is (are) hydrogen atom(s) is desirable, and a vinyl ether group, the compound in which R¹, R² and R³ all are hydrogen atoms, is most preferred.

In the present invention, it is possible to use various compounds so far as they contain at least two enol ether groups. However, it is desirable for these compounds to have a boiling point of 60°C or above under atmospheric pressure. Preferred examples of component (a) include a vinyl ether compound represented by formula (II) or (III):

A - (-O-(R⁴-O)ₙ-CH=CH₂)ₘ (II)

A - (-B-R⁴-O-CH=CH₂)ₘ (III)

wherein A represents a m-valent alkyl, aryl or heterocyclic group (preferably those having 1 to 50 carbon atoms), B represents -COO-, -NHCOO- or -NHCONH-, R⁴ represents a straight-chain or branched alkylene group containing 1 to 10 carbon atoms, n represents 0 or an integer of 1 to 10, and m represents an integer of 2 to 6.

The compounds represented by formula (II) can be synthesized using the methods described, e.g., in Stephen C. Lapin, Polymers Paint Colour Journal, 179(4237), 321(1988), that is, the reaction of a polyhydric alcohol or a polyhydric phenol with acetylene and the reaction of a polyhydric alcohol or a polyhydric phenol with a halogenated alkyl vinyl ether.

Specific examples of such compounds include ethylene glycol divinyl ether, triethylene glycol divinyl ether, 1,3-butanediol divinyl ether, tetramethylene glycol divinyl ether, neopentyl glycol divinyl ether, trimethylolpropane trivinyl ether, trimethylolethane trivinyl ether, hexanediol divinyl ether, 1,4-cyclohexanediol divinyl ether, tetraethylene glycol divinyl ether, pentaerythritol divinyl ether, pentaerythritol trivinyl ether, pentaerythritol tetravinyl ether, sorbitol tetravinyl ether, sorbitol pentavinyl ether, ethylene glycol diethylenevinyl ether, triethylenen glycol diethylenevinyl ether, ethylene glycol dipropylenevinyl ether, triethylene glycol diethylenevinyl ether, trimethylolpropane triethylenevinyl ether, trimethylolpropane diethylenevinyl ether, pentaerythritol diethylenevinyl ether, pentaerythritol triethylenevinyl ether, pentaerythritol tetraethylenevinyl ether, 1,2-di(vinylethermethoxy)benzene, 1,2-di(vinyletherethoxy)benzene, and Compounds from (II-1) to (II-41) illustrated below. However, the present invention should not be construed as being limited to these compounds.

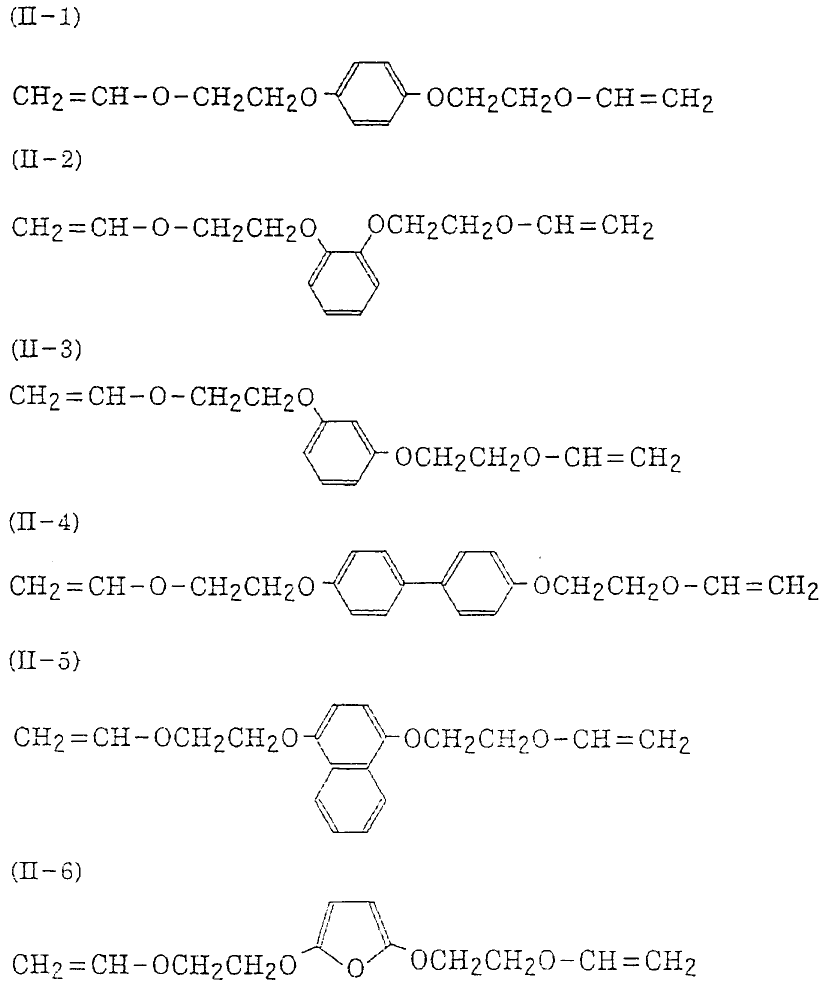

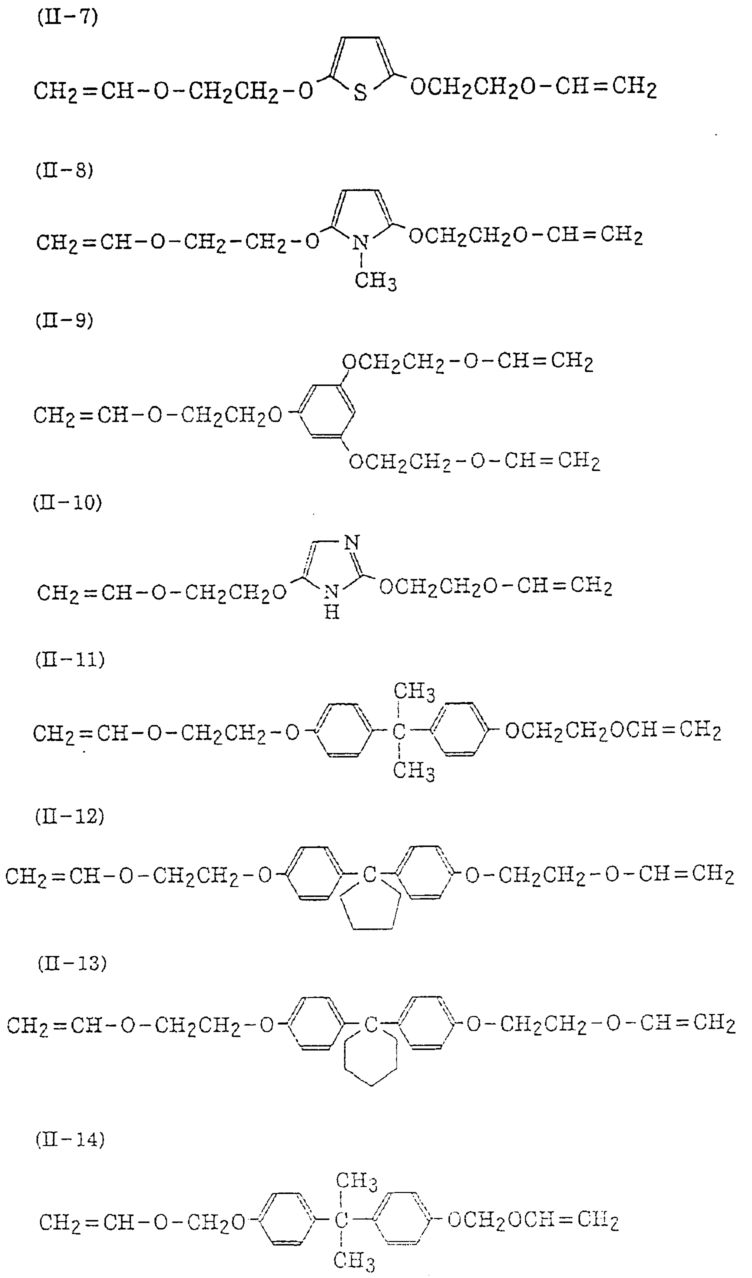

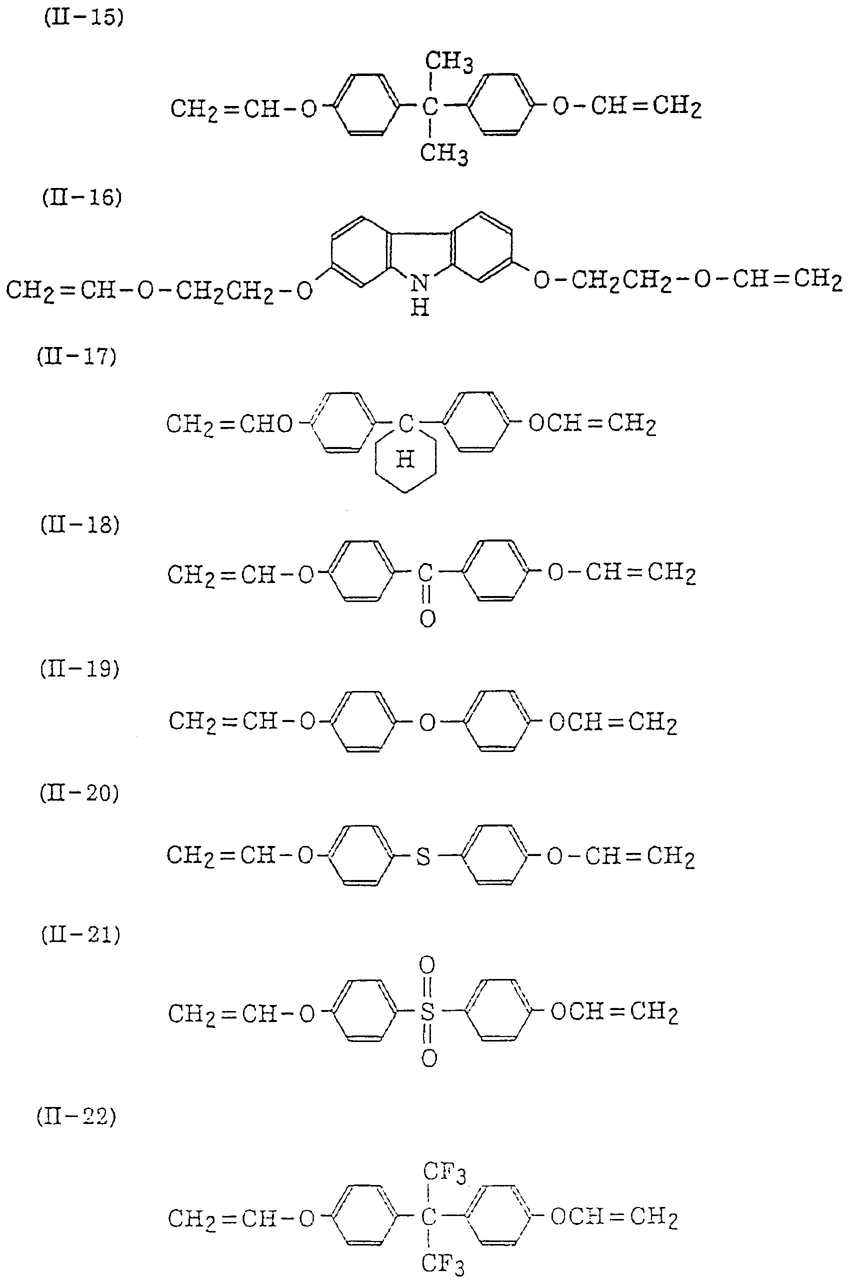

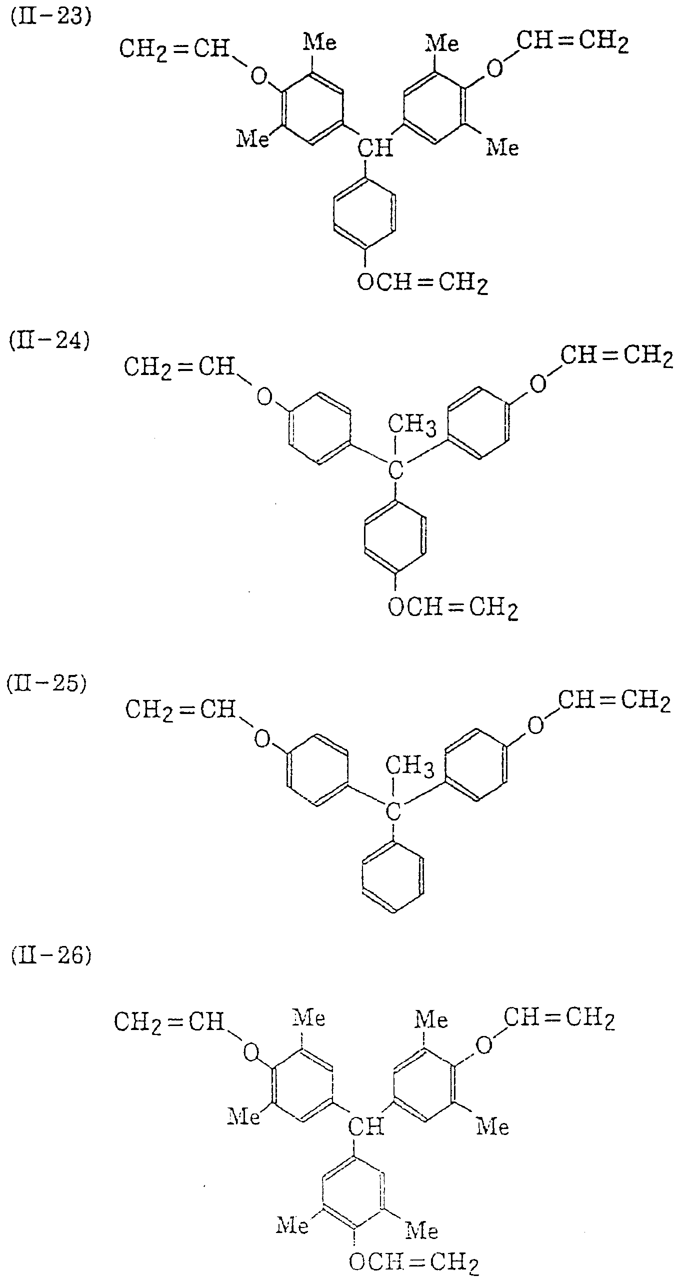

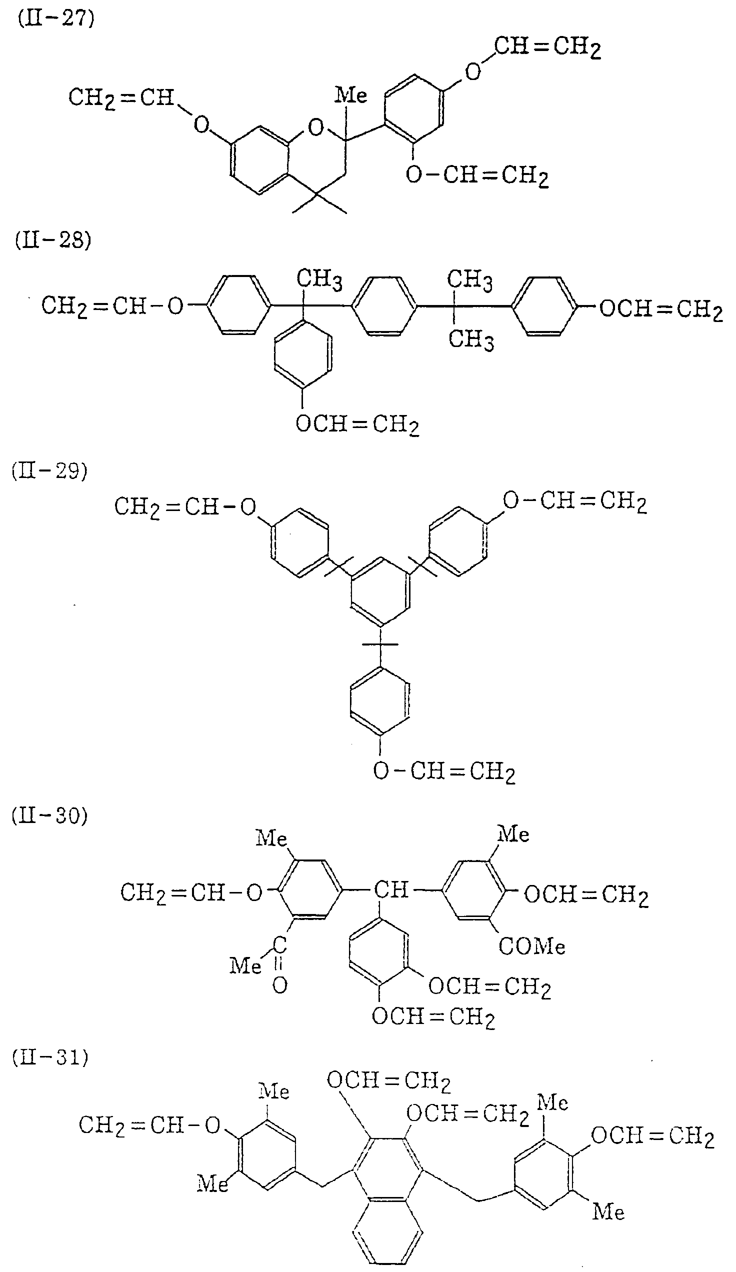

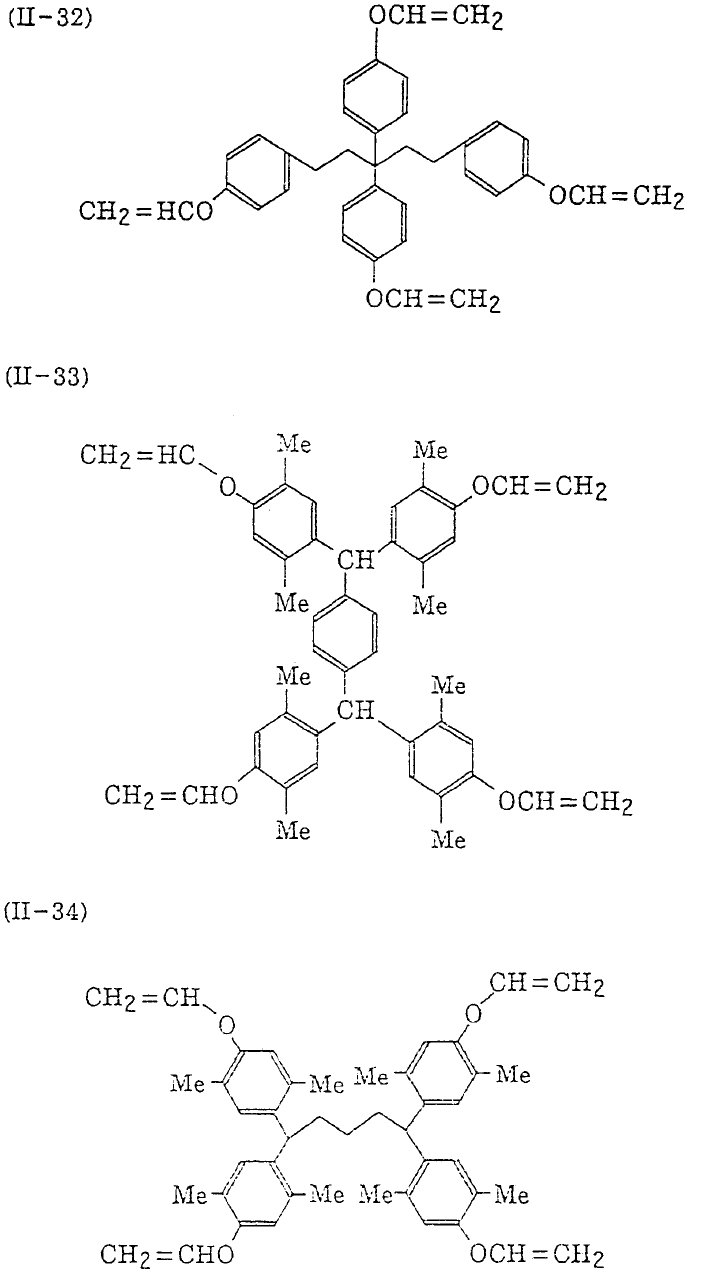

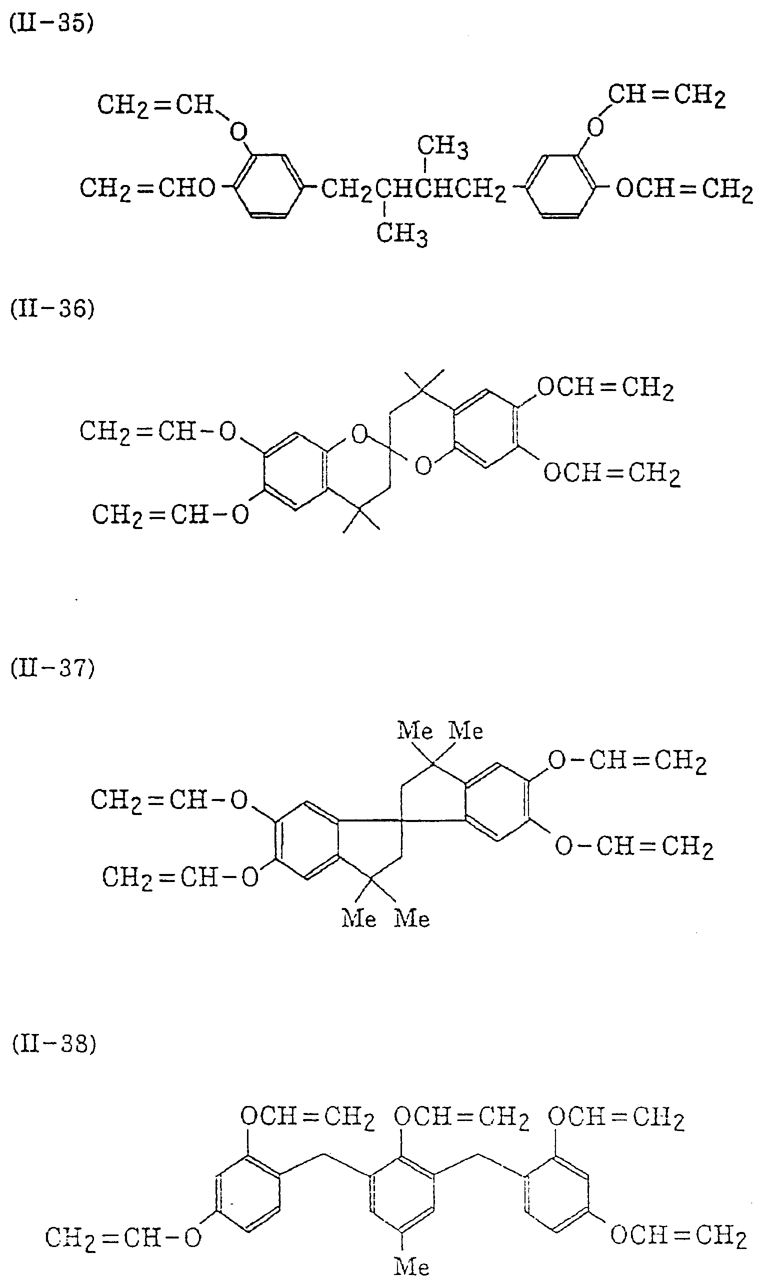

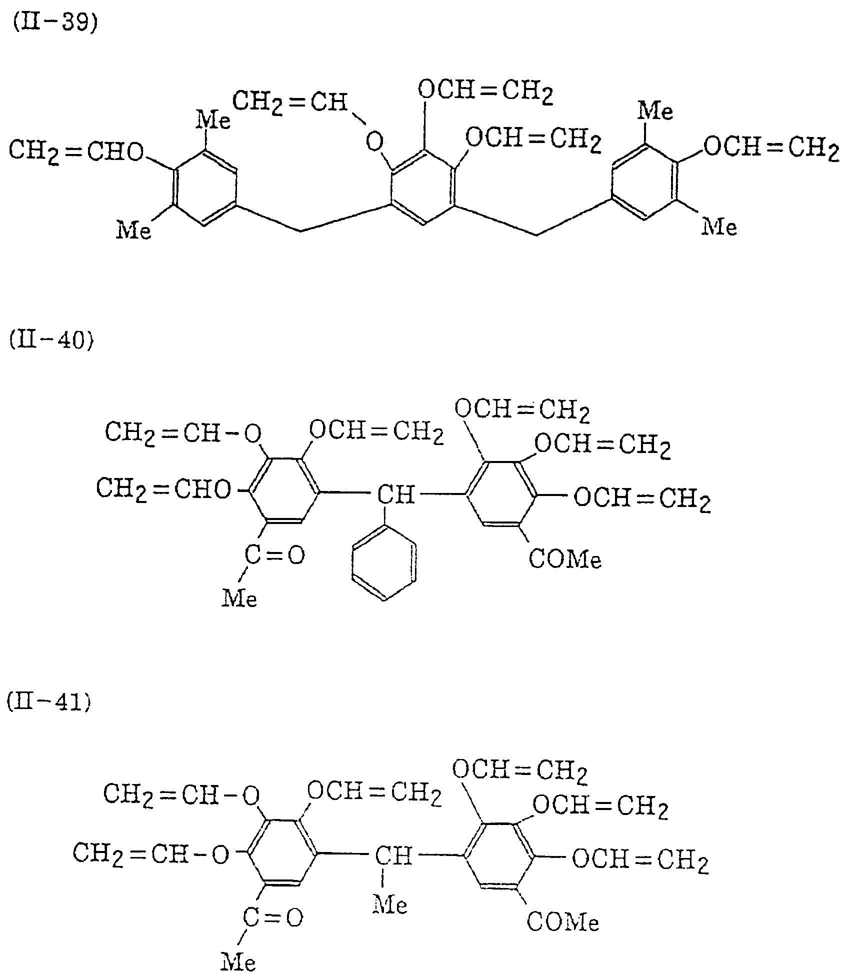

On the other hand, the compounds represented by formula (III) (in case of B= -CO-O-) can be produced through the reaction of a polycarboxylic acid with a halogenated alkyl vinyl ether.

Specific examples of such compounds include terephthalyl diethylenevinyl ether, phthalyl diethylenevinyl ether, isophthalyl diethylenevinyl ether, phthalyl dipropylenevinyl ether, terephthalyl dipropylenevinyl ether, isophthalyl dipropylenevinyl ether, maleyl diethylenevinyl ether, fumaryl diethylenevinyl ether, and itaconyl diethylenevinyl ether. However, the invention should not be construed as being limited to these compounds.

Preferred examples of the vinyl ether group-containing compound include those synthesized by the reaction of an active hydrogen-containing vinyl ether compound represented by formula (IV), (V) or (VI) with an isocyanate group-containing compound:

CH₂=CH-O-R⁵-OH (IV)

CH₂=CH-O-R⁵-COOH (V)

CH₂=CH-O-R⁵-NH₂ (VI)

wherein R⁵ represents a straight-chain or branched alkylene group containing 1 to 10 carbon atoms such as methylene, trimethylene, and 2,2-dimethyltrimethylene. As for the isocyanate group-containing compounds, there can be used the compounds described, e.g., in Kakyozai Handbook (Crosslinking Agent Handbook) , Taiseisha, 1981.

Specific examples of an isocyanate group-containing compound include polyisocyanates such as triphenylmethane triisocyanate, diphenylmethane diisocyanate, tolylene diisocyanate, 2,4-tolylene diisocyanate dimer, naphthalene-1,5-diisocyanate, o-tolylene diisocyanate, polymethylenepolyphenyl isocyanate, and hexamethylene diisocyanate, and polyisocyanate adducts such as tolylenediisocyanate-methylolpropane adduct, hexamethylenediisocyanate-water adduct, and xylylenediisocyanate-trimethylolpropane adduct.

Various compounds containing terminal vinyl ether groups can be obtained by reacting an isocyanate group-containing compound as described above with an active hydrogen-containing vinyl ether compound. Specific examples of such compounds, from (VII-1) to (VII-15), are illustrated below. However, the invention should not be construed as being limited to these compounds.

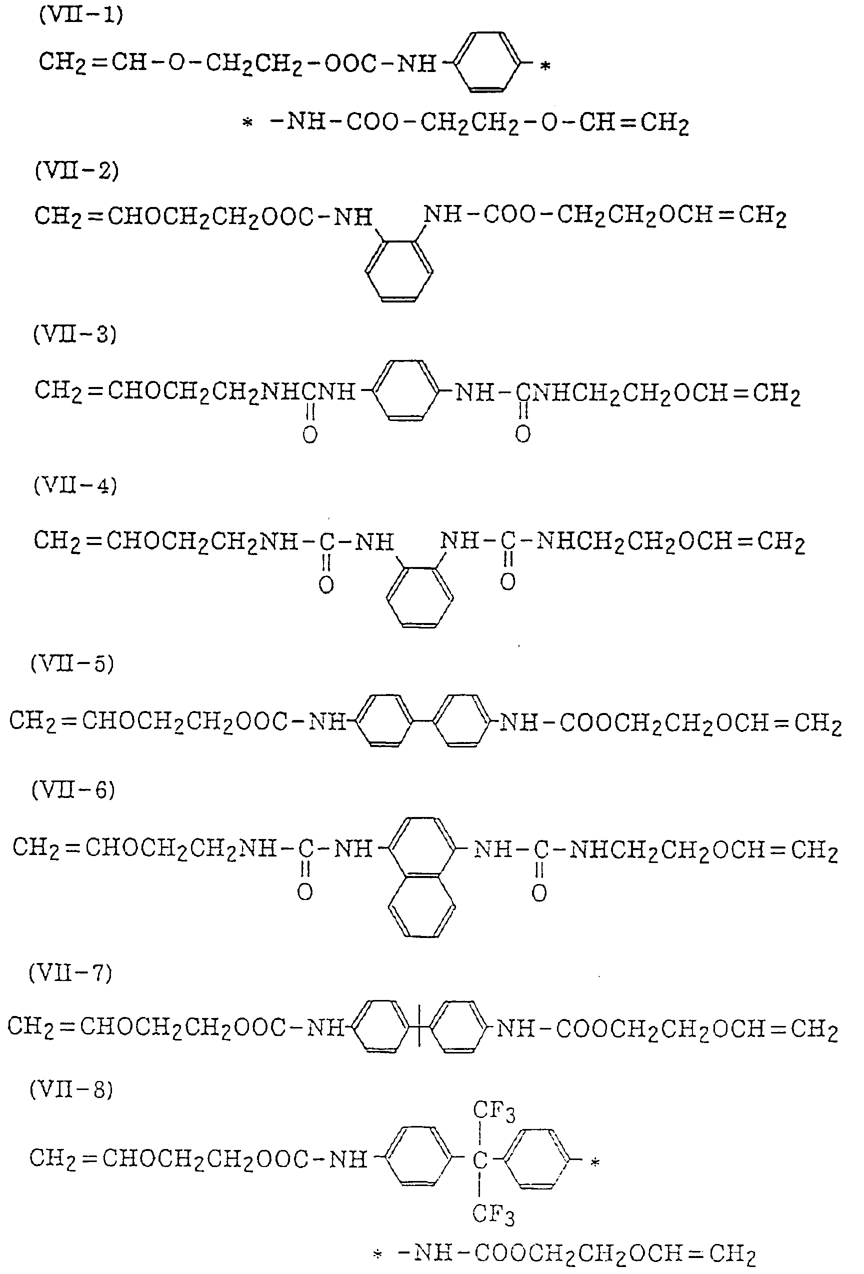

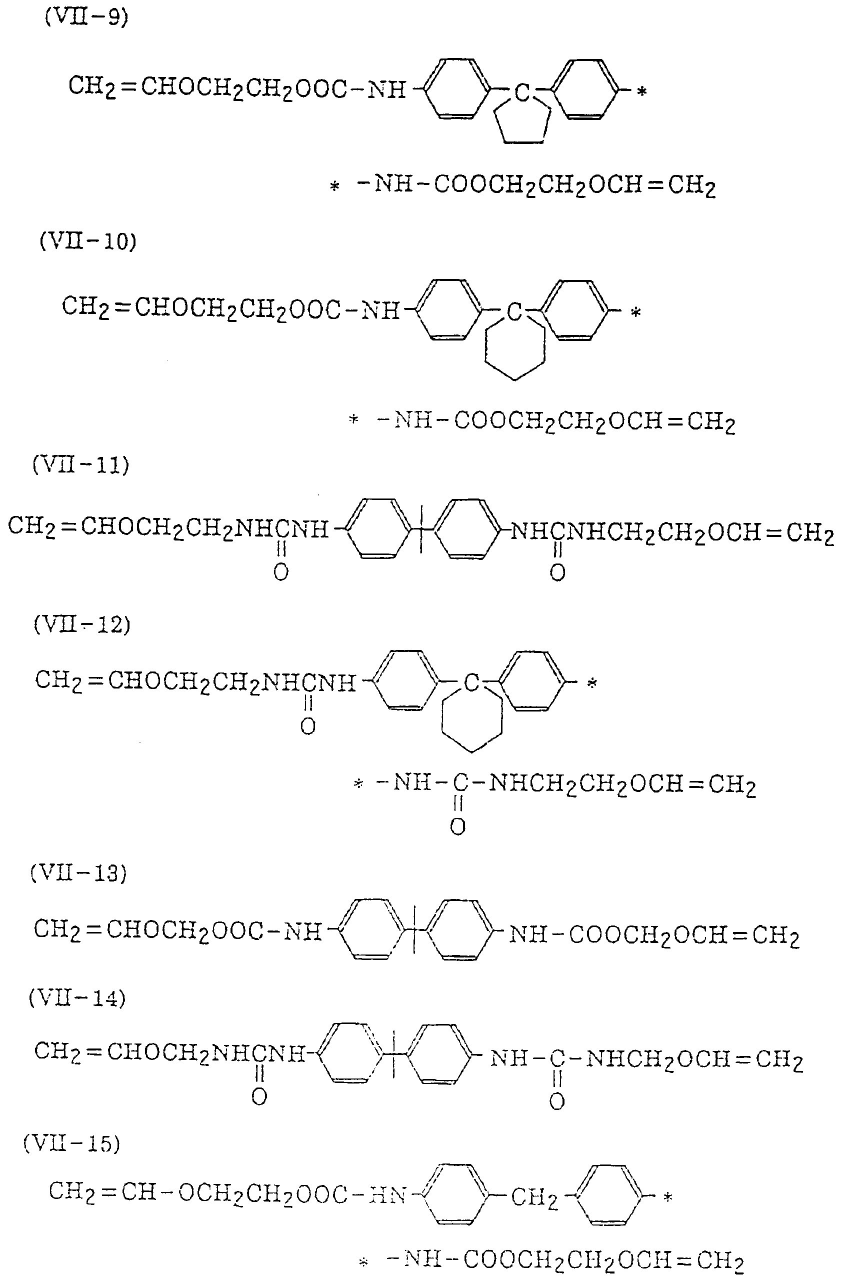

The above-illustrated compounds containing at least two vinyl ether groups can be used alone, but they may be used as a mixture of several thereof.

The added amount of the vinyl ether groups-containing compound is generally in the range of 1 to 80 % by weight, preferably 5 to 50 % by weight based on the whole solid content of the photosensitive composition.

A linear high polymer (b) used in the present invention, which contains both acid and hydroxyl groups, is thermally cross-linked with the compound (a) which contains at least two enol ether groups, and the cross-linked parts are decomposed by an acid with high efficiency. Such a linear high polymer (b) can be arbitrarily chosen from those which comprise monomers having an acid group and/or a hydroxyl group, provided that such monomers are introduced therein in definite proportion ranges.

More specifically, the linear high polymer (b) used in the present invention is a copolymer of an acid group-containing monomer and a hydroxyl group-containing monomer, or a monomer containing both acid and hydroxyl groups, and a monomer containing neither acid group nor hydroxyl group, and the copolymer contains these monomers in a specified molar ratio.

When the linear high polymer (b) is a copolymer of an acid group-containing monomer, a hydroxyl group-containing monomer and a monomer containing neither acid group nor hydroxyl group, a ratio among these monomer units, (acid group-containing monomer)/(hydroxyl group-containing monomer)/(monomer containing neither acid group nor hydroxyl group), is in the range (5-30)/(5-30)/(90-40) by mole. Preferably, the ratio is in the range (5-25)/(5-25)/(90-50), especially (10-25)/(10-25)/80-50), by mole.

When the linear high polymer (b) is a copolymer of a monomer containing both acid group and hydroxyl group and a monomer containing neither acid group nor hydroxyl group, a ratio between these monomer units, (monomer containing both acid group and hydroxyl group)/(monomer containing neither acid group nor hydroxyl group), is in the range (5-30)/(95-70) by mole. Preferably, the ratio is in the range (5-25)/(95-75), especially (10-25)/(90-75), by mole.

In case the proportion of the acid group-containing monomer units in the copolymer is less than 5 mole %, the development proceeds slowly, and so a long time is required for the formation of images; while if it is more than 30 mole %, the loosening of the photosensitive coat occurs during development. On the other hand, scum generates when the proportion of the hydroxyl group-containing monomer units in the copolymer is more than 30 mole %; while when it is less than 5 mole %, the photosensitive composition undergoes a great change in sensitivity with the lapse of time to fail in meeting the performance requirements for application to a lithographic printing plate. In addition, if the proportion of the monomer units containing both acid group and hydroxyl group is out of the aforesaid range, the resulting copolymer is responsible for the same unfavorable phenomena as described above.

The above-described linear high polymers can be synthesized according to known methods for obtaining general linear high polymers. They can be obtained, for instance, by copolymerizing an acid group-containing monomer, a hydroxyl group-containing monomer and a copolymerizable monomer of the kind which contains neither acid group nor hydroxyl group. Examples of an acid group include a carboxylic acid group, a sulfonic acid group, a phosphoric acid group, and a sulfonamide group. In particular, a carboxylic acid group and a sulfonic acid group are preferred.

Examples of an acid group-containing monomer include acrylic acid, methacrylic acid, maleic acid, itaconic acid, crotonic acid, isocrotonic acid, p-vinylbenzoic acid, p-vinylbenzenesulfonic acid, p-vinylcinnamic acid, maleic acid monomethyl ether and maleic acid monoethyl ether, but the invention should not be construed as being limited to those examples. Of those acids cited above, acrylic acid, methacrylic acid, maleic acid, itaconic acid and p-vinylbenzoic acid are particularly preferred.

Examples of a hydroxyl group-containing monomer include 2-hydroxyethyl acrylate, 2-hydroxyethyl methacrylate, 2-hydroxylethylstyrene, p-2-hydroxyethylstyrene, p-hydroxystyrene, 2,3-dihydroxypropyl acrylate and 2,3-dihydroxypropyl methacrylate. However, the invention should not be construed as being limited to these examples. Also, the introduction of hydroxyl groups into a copolymer can be effected by saponifying a vinyl acetate copolymer. Of the above-cited monomers, 2-hydroxyethyl acrylate, 2-hydroxyethyl methacrylate, 2,3-dihydroxypropyl acrylate and 2,3-dihydroxypropyl methacrylate are preferred.

As for the other monomers capable of copolymerizing with the above-described monomers, examples thereof are acrylonitrile, acrylamide, methacrylamide, methyl acrylate, ethyl acrylate, propyl acrylate, butyl acrylate, methyl methacrylate, ethyl methacrylate, propyl methacrylate, butyl methacrylate, benzyl acrylate, benzyl methacrylate, vinyl benzoate, vinyl chloride, vinylidene chloride, styrene, vinyl acetate, N-(4-sulfamoylphenyl)methacrylamide, N-phenylphosphonylmethacrylamide, butadiene, and chloroprene, isoprene. However, the invention should not be construed as being limited to those monomers.

In a case of the copolymer constituted of acid group-containing monomers, hydroxyl group-containing monomers and other copolymerizable monomers, it is possible to copolymerize arbitrary number of monomers in an arbitrary combination, provided that the molar ratio among the monomers used is within the aforementioned range.

The monomer containing both acid group and hydroxyl group may be any of monomers in which both acid group and hydroxyl group are contained. Examples of such a monomer include an acid group-containing hydroxy compound, an acid group-containing dihydroxy compound and an acid group-containing trihydroxy compound. More specifically, the compounds illustrated below can be instanced. However, the invention should not be construed as being limited to these compounds. 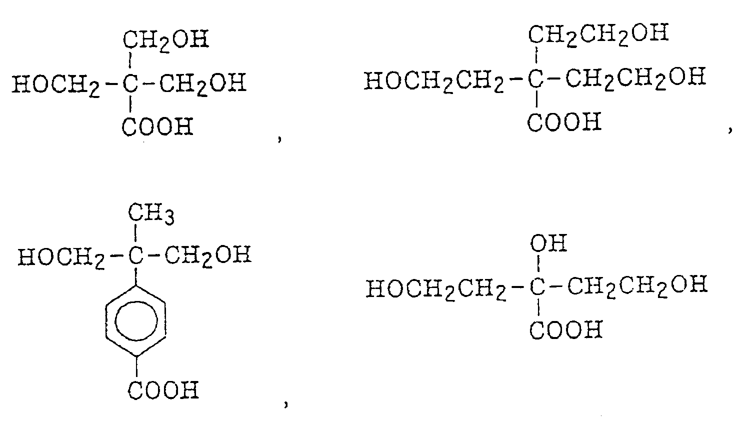
The copolymer of a monomer containing both acid group and hydroxyl group and a monomer containing neither acid group nor hydroxyl group can be obtained, for example, by the reaction of an acid group-containing trihydroxy compound with a diisocyanate compound, the reaction of a mixture of an acid group-containing dihydroxy compound and a trihydroxy compound with a diisocyanate compound, the co-condensation of an acid group-containing trihydroxy compound and a dicarboxylic acid compound, the co-condensation of a mixture of an acid group-containing dihydroxy compound with a trihydroxy compound and a dicarboxylic acid compound, and the co-condensation of a trihydroxy compound and a tricarboxylic acid. For instance, one of such copolymers can be obtained in accordance with a reaction scheme as illustrated below: 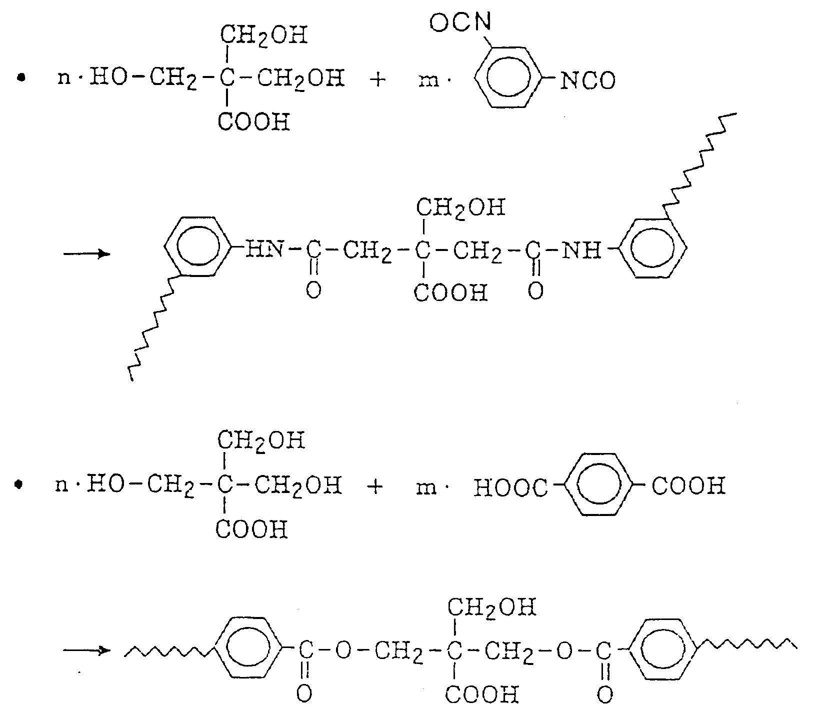
The linear high polymer (b) may be a random-copolymer or a block-copolymer, but a random-copolymer is preferred because it can provide a film composed of uniform networks.

Specific examples of a linear high polymer which can be used in the present invention are set forth below. However, the content of the present invention should not be construed as being limited to these copolymers.
P-1: Methacrylic acid/benzyl methacrylate/2-hydroxyethyl methacrylate (20/60/20, by mole %) copolymer, Mw = 3.7×10⁴.
P-2: Methacrylic acid/benzyl methacrylate/2-hydroxyethyl methacrylate (20/50/30, by mole %) copolymer, Mw = 3.9×10⁴.
P-3: Methacrylic acid/benzyl methacrylate/2-hydroxyethyl methacrylate (30/50/20, by mole %) copolymer, Mw = 3.5×10⁴.
P-4: Methacrylic acid/benzyl methacrylate/2-hydroxyethyl methacrylate (10/70/20, by mole %) copolymer, Mw = 3.4×10⁴.
P-5: Methacrylic acid/benzyl methacrylate/2-hydroxyethyl methacrylate (10/80/10, by mole %) copolymer, Mw = 3.4×10⁴.
P-6: Methacrylic acid/methyl methacrylate/2-hydroxyethyl methacrylate/acrylonitrile (10/25/30/35, by mole %) copolymer, Mw = 2.9×10⁴.
P-7: Vinylbenzoate/methyl methacrylate/2-hydroxyethyl acrylate (20/60/20, by mole %) copolymer, Mw = 3.7×10⁴.
P-8: 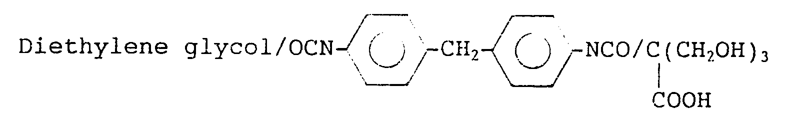 (30/50/20, by mole %) copolymer, Mw = 8,300.
P-9: 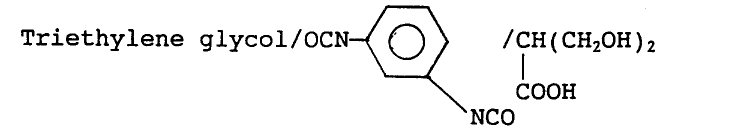 (25/50/25, by mole %) copolymer, Mw = 4,900.
P-10: 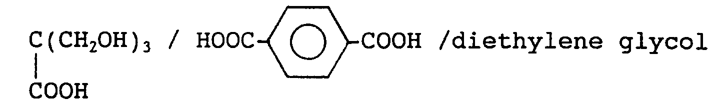 (20/50/30, mole %) copolymer, Mw = 23,000.
P-11: 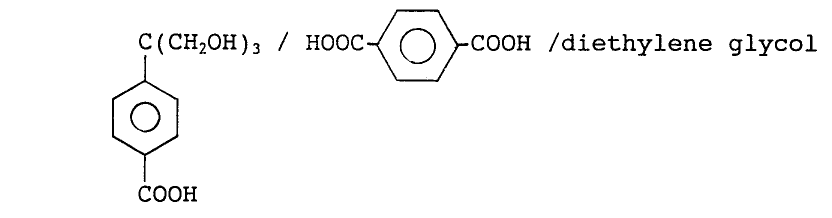 (20/50/30, by mole %) copolymer, Mw = 18,000.

In the above, "Mw" means a weight average molecular weight.

The linear high polymer (b) used in the present invention has no particular limitation on molecular weight, but it has a weight average molecular weight ranging generally from 1,000 to 1,000,000, preferably from 1,500 to 200,000.

Linear high polymers as illustrated above can be used alone, but they may be used as a mixture of several thereof. The proportion of linear high polymer(s) used in a photosensitive composition is generally in the range of 1 to 95 % by weight, preferably in the range of 20 to 90 % by weight, based on the whole solid content of the photosensitive composition.

Compound (c), which can be decomposed by irradiation with active rays or radiation to produce an acid, can be appropriately chosen from among photoinitiators for cationic photopolymerization, photoinitiators for radical photopolymerization, photodecolorization agents for dyes, photodiscoloring agents, known compounds capable of producing acids by exposure to light which are used for micro resist and the like, and mixtures of two or more of the above-cited ones.

Suitable examples of such agents include the diazonium salts described in S. I. Schlesinger, Photogr. Sci. Eng., 18, 387(1974) and T. S. Bal et al., Polymer, 21, 423(1980); the ammonium salts disclosed in U.S. Patents 4,069,055, 4,069,056 and Re 27,992, and Japanese Patent Application No. 03-140140; the phosphonium salts described in D. C. Necker, et al., Macromolecules, 17, 2468(1984), C. S. Wen et al., Teh, Proc. Conf. Rad. Curing ASIA, p.478, Tokyo, Oct(1988), and U.S. Patents 4,069,055 and 4,069,056; the iodonium salts described in J. V. Crivello et al., Macromolecules, 10(6) 1307(1977), Chem. & Eng. News, Nov. 28, p.31 (1988), European Patent 104,143, U.S. Patents 339,049 and 410,201, JP-A-2-150848, JP-A-2-296514; the sulfonium salts described in J. V. Crivello et al., Polymer J., 17, 73(1985), J. V. Crivello et al., J. Org. Chem., 43, 3055(1978), W. R. Watt et al., J. Polymer Sci., Polymer Chem. Ed., 22, 1789(1984), J. V. Crivello et al., Polymer Bull., 14, 279(1985), J. V. Crivello et al., Macromolecules, 14(5), 1141(1981), J. V. Crivello et al., J. Polymer Sci., Polymer Chem. Ed., 17, 2877(1979), European Patents 370,693, 3,902,114, 233,567, 297,443 and 297,552, U.S. Patents 4,933,377, 161,811, 410,201, 339,049, 4,760,013, 4,734,444 and 2,833,827, and German Patents 2,904,626, 3,604,580 and 3,604,581; the selenonium salts described in J. V. Crivello et al., Macromolecules, 10(6), 1307 (1977), and J. V. Crivello et al., J. Polymer Sci., Polymer Chem. Ed., 17, 1047 (1979); the onium salts, such as arsonium salts, described in C. S. Wen et al., Teh, Proc. Conf. Rad. Curing ASIA, p478 Tokyo, Oct(1988); the organohalogen compounds disclosed in U.S. Patent 3,905,815, JP-B-46-4605, JP-A-48-36281, JP-A-55-32070, JP-A-60-239736, JP-A-61-169835, JP-A-61-169837, JP-A-62-58241, JP-A-62-212401, JP-A-63-70243 and JP-A-63-298339; the organometal/organohalogen compounds described in K. Meier et al., J. Rad. Curing, 13(4), 26(1986), T. P. Gill et al., Inorg. Chem., 19, 3007(1980), D. Astruc, Acc. Chem. Res., 19(12), 377(1896), and JP-A-2-161445; the photo-acid generators containing protective groups of o-nitrobenzyl type as described in S. Hayase et al., J. Polymer Sci., 25, 753(1987), E. Reichmanis et al., J. Polymer Sci., Polymer Chem. Ed., 23, 1(1985), Q. Q. Zhu et al., J. Photochem., 36, 85, 39, 317(1987), B. Amit et al., Tetrahedron Lett., (24) 2205(1973), D. H. R. Barton et al., J. Chem. Soc., 3571 (1965), P. M. Collins et al., J. Chem. Soc., Perkin I, 1695(1975), M. Rudinstein et al., Tetrahedron Lett., (17), 1445(1975), J. W. Walker et al., J. Am. Chem. Soc., 110, 7170(1988), S. C. Busman et al., J. Imaging Technol., 11(4), 191(1985), H. M. Houlihan et al., Macromolecules, 21, 2001(1988), P. M. Collins et al., J. Chem. Soc., Chem. Commun., 532(1972), S. Hayase et al., Macromolecules, 18, 1799(1985), E. Reichmanis et al., J. Electrochem. Soc., Solid State Sci., Technol., 130(6), F. M. Houlihan et al., Macromolecules, 21, 2001(1988), European Patents 0290,750, 046,083 and 156,535, 271,851 and 0,388,343, U.S. Patents 3,901,710 and 4,181,531, JP-A-60-198538 and JP-A-53-133022; the compounds producing sulfonic acid by photolysis, represented by iminosulfonates and so on, as described in M. Tunooka et al., Polymer Preprints Japan, 38(8), G. Berner et al., J. Rad. Curing, 13(4), W. J. Mijs et al., Coating Technol., 55(697), 45(1983), Akzo, H. Adachi et al., Polymer Preprints, Japan, 37(3), European Patents 199,672, 84515, 199,672, 044,115 and 0101,122, U.S. Patents 4,618,564, 4,371,605 and 4,431,774, JP-A-64-18143, JP-A-2-245756 and Japanese Patent Application No. 3-140109; and the disulfone compounds disclosed in JP-A-61-166544.

In addition, the polymers having the main or side chains in which are introduced the above-cited groups or compounds which can produce acids upon exposure to light, can be used, and examples thereof include the compounds as described in M. E. Woodhouse et al., J. Am. Chem. Soc., 104, 5586(1982), S. P. Pappas et al., J. Imaging Sci., 30(5), 218(1986), S. Kondo et al., Makromol. Chem.,, Rapid Commun., 9, 625(1988), Y. Yamada et al., Makromol. Chem., 152, 153, 163(1972), J. V. Crivello et al., J. Polymer Sci., Polymer Chem. Ed., 17, 3845(1979), U.S. Patent 3,849,137, German Patent 3,914,407, JP-A-63-26653, JP-A-55-164824, JP-A-62-69263, JP-A-63-146038, JP-A-63-163452, JP-A-62-153853 and JP-A-63-146029.

Also, there can be used the compounds capable of producing acids upon exposure to light, as described in V. N. R. Pillai, Synthesis, (1) 1(1980), A. Abad et al., Tetrahedron Lett., (47) 4555(1971), D. H. R. Barton et al., J. Chem. Soc., (C), 329(1970), U.S. Patent 3,779,778 and European Patent 126,712.

Of the above-described compounds which are decomposed by irradiation with active rays or radiation to produce acids, the following are particularly useful ones:
(1) Trihalomethyl substituent-containing oxazole derivatives represented by formula (VIII) or trihalomethyl substituent-containing s-triazine derivatives represented by formula (IX); 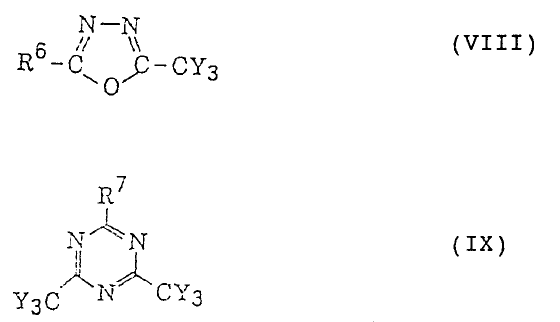 wherein R⁶ is a substituted or unsubstituted aryl or alkenyl group, R⁷ is a substituted or unsubstituted aryl, alkenyl or alkyl group or -CY₃, Y is a chlorine or bromine atom, and plural Y's may be the same or different.
   Specific examples of the oxazole derivative (VIII) and those of the s-triazine derivative (IX) include Compounds (VIII-1) to (VIII-8) and Compounds (IX-1) to (IX-10), respectively, illustrated below. However, the foregoing derivatives applicable to the invention should not be construed as being limited to the compounds illustrated. 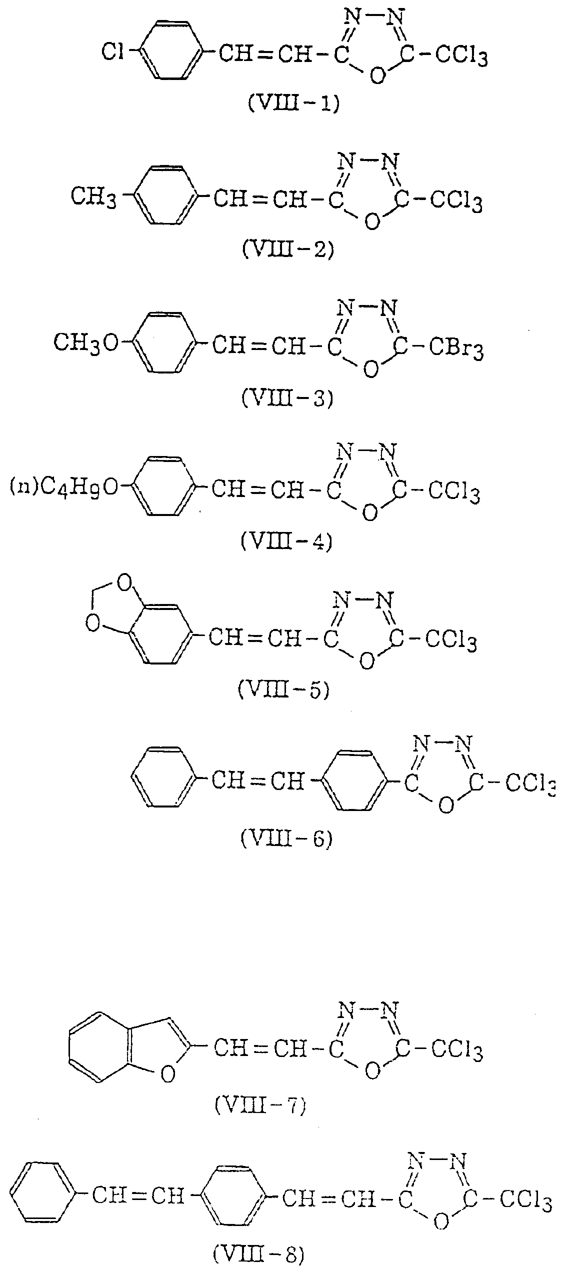 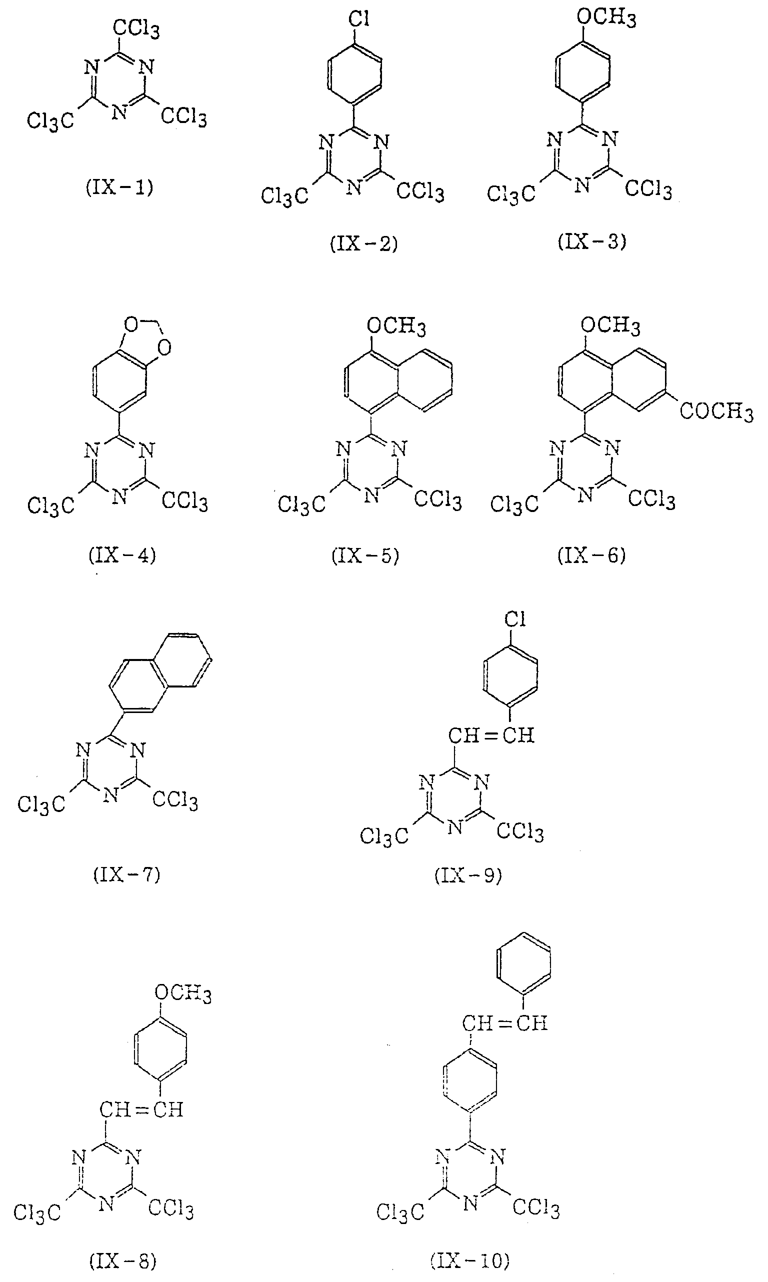
(2) Iodonium salts represented by formula (X) and sulfonium salts represented by formula (XI); 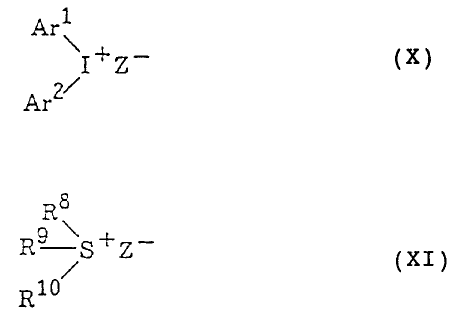 Herein, Ar¹ and Ar² each independently represent a substituted or unsubstituted aryl group. Suitable examples of a substituent which the aryl group can have include an alkyl group, a haloalkyl group, a cycloalkyl group, an aryl group, an alkoxy group, a nitro group, a carboxyl group, an alkoxycarbonyl group, a hydroxy group, a mercapto group and a halogen atom.
   R⁸, R⁹ and R¹⁰ each independently represent a substituted or unsubstituted alkyl or aryl group. Preferably, they each represent an aryl group containing 6 to 14 carbon atoms, an alkyl group containing 1 to 8 carbon atoms, or a substituted derivative thereof. As for the suitable substituents, those which the aryl group can have are an alkoxy group containing 1 to 8 carbon atoms, an alkyl group containing 1 to 8 carbon atoms, a nitro group, a carboxyl group, a hydroxy group or a halogen atom; while those which the alkyl group can have are an alkoxy group containing 1 to 8 carbon atoms, a carboxyl group and an alkoxycarbonyl group.
   Z⁻ represents a counter anion, with specific examples including BF₄⁻, AsF₆⁻, PF₆⁻, SbF₆⁻, SiF₆²⁻, ClO₄⁻, CF₃SO⁻, BPh₄⁻ (Ph= phenyl), condensed polynuclear aromatic sulfonic acid anions such as naphthalene-1-sulfonic acid anion, anthraquinonesulfonic acid anion and the like, and dyes containing sulfonic acid group(s). However, the anions applicable to the foregoing salts should not be construed as being limited to these examples.
   Also, any two among R⁸, R⁹ and R¹⁰, or Ar¹ and Ar² may combine with each other directly or via a substituent.
   The onium salts represented by formulae (X) and (XI) are known compounds, and can be synthesized using the methods as described, e.g., in J. W. Knapczyk et al., J. Am. Chem. Soc., 91, 145(1969), A. L. Maycol et al., J. Org. Chem., 35, 2532(1970), E. Goethas et al., Bull. Soc. Chem. Belg., 73, 546(1964), H. M. Leicester, J. Am. Chem. Soc., 51, 3587(1929), J. B. Crivello et al., J. Polym. Chem. Chem. Ed., 18, 2677(1980), U.S. Patents 2,807,648 and 4,247,473, and JP-A-53-101331.
   Specific examples of onium compounds of formulae (X) and (XI) include Compounds (X-1) to (X-22) and Compounds (XI-1) to (XI-34), respectively, illustrated below. However, the onium compounds applicable to the invention should not be construed as being limited to the compounds illustrated. 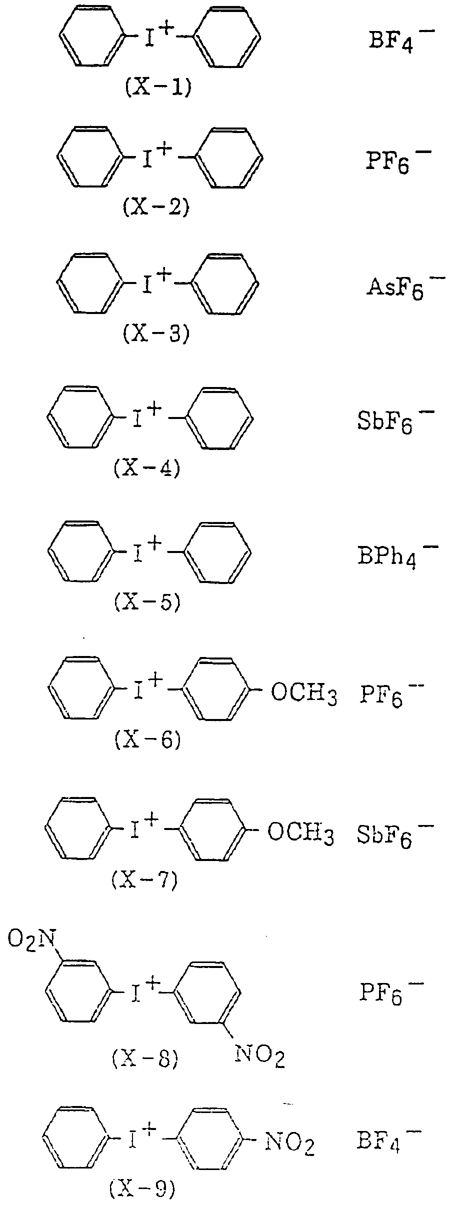 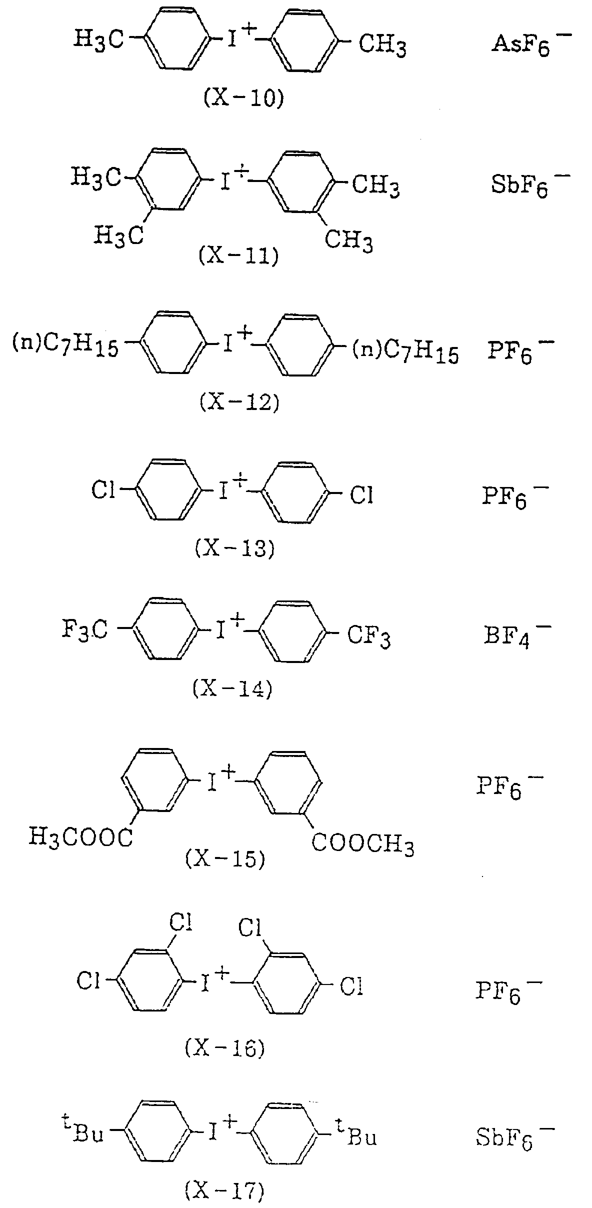 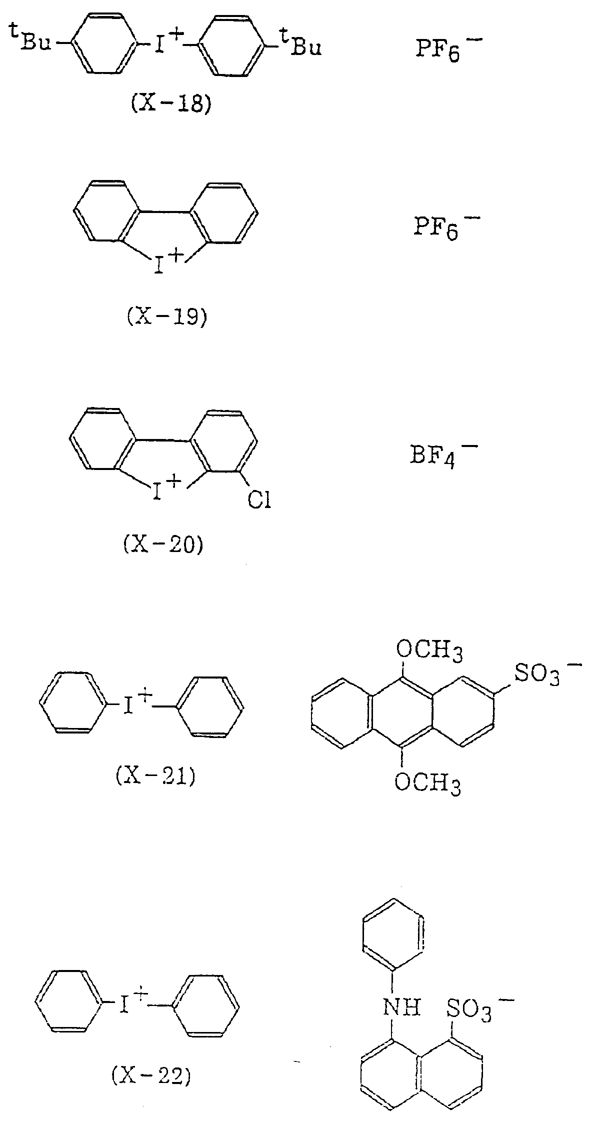 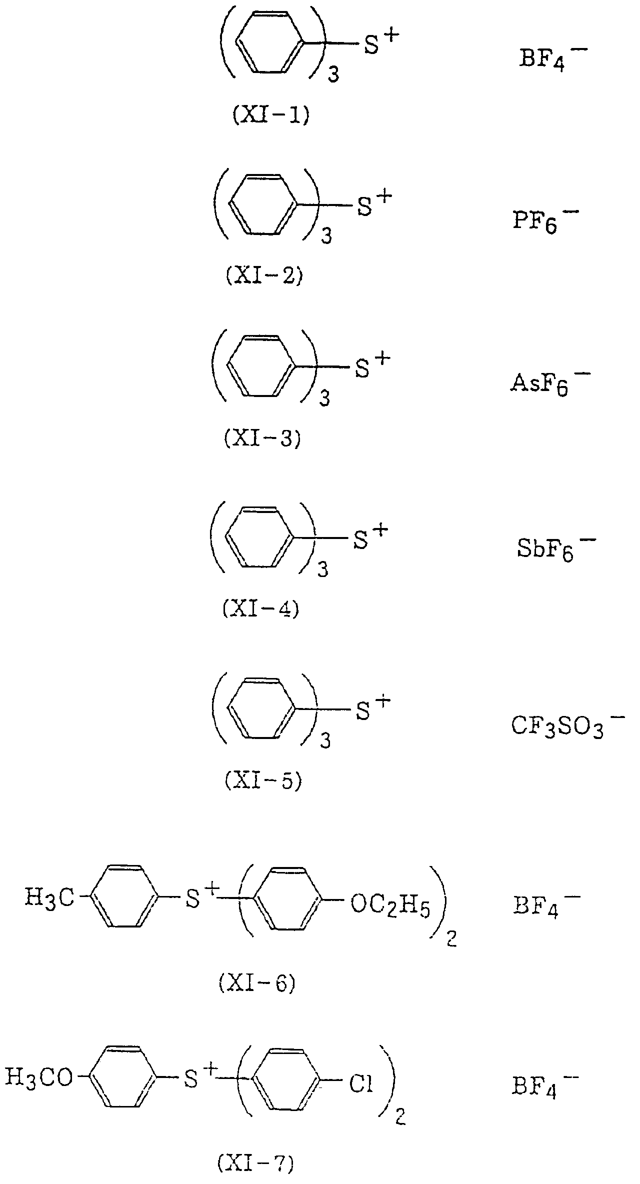 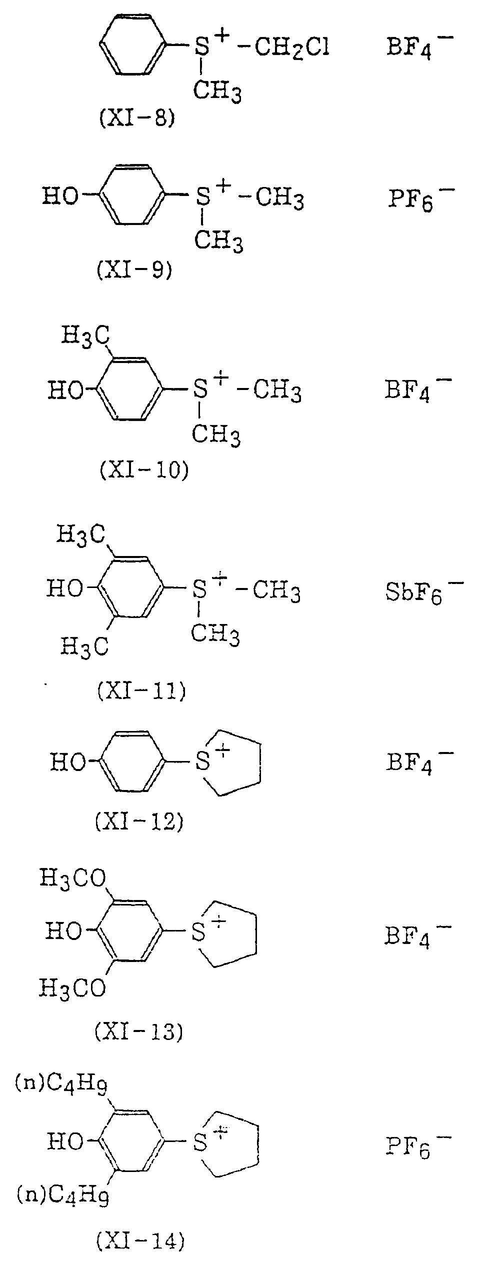 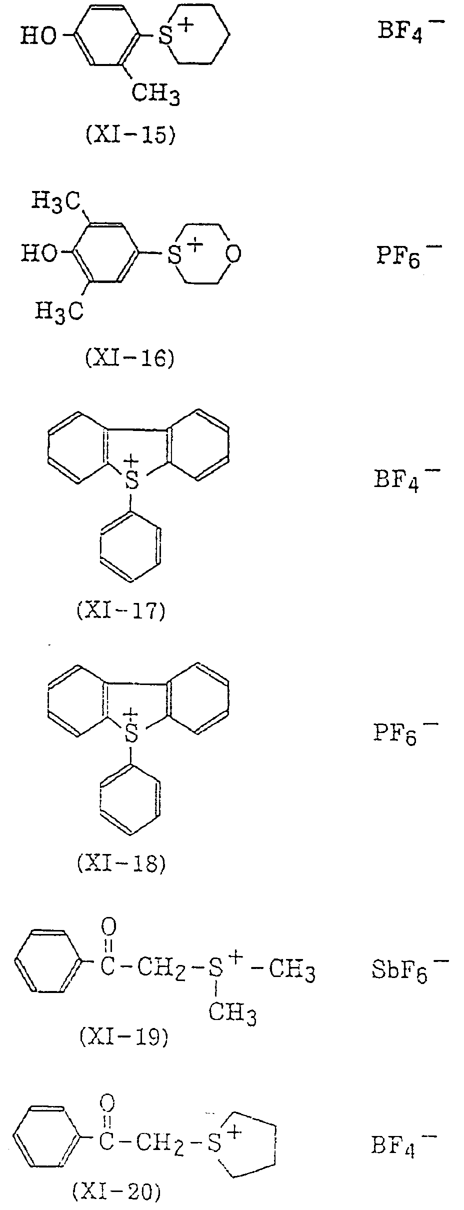 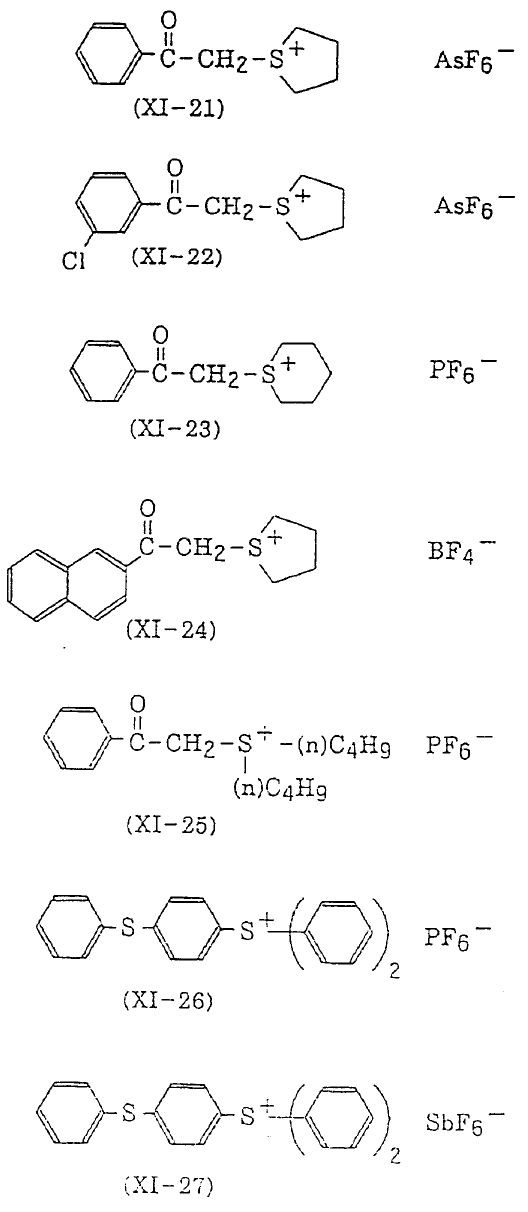 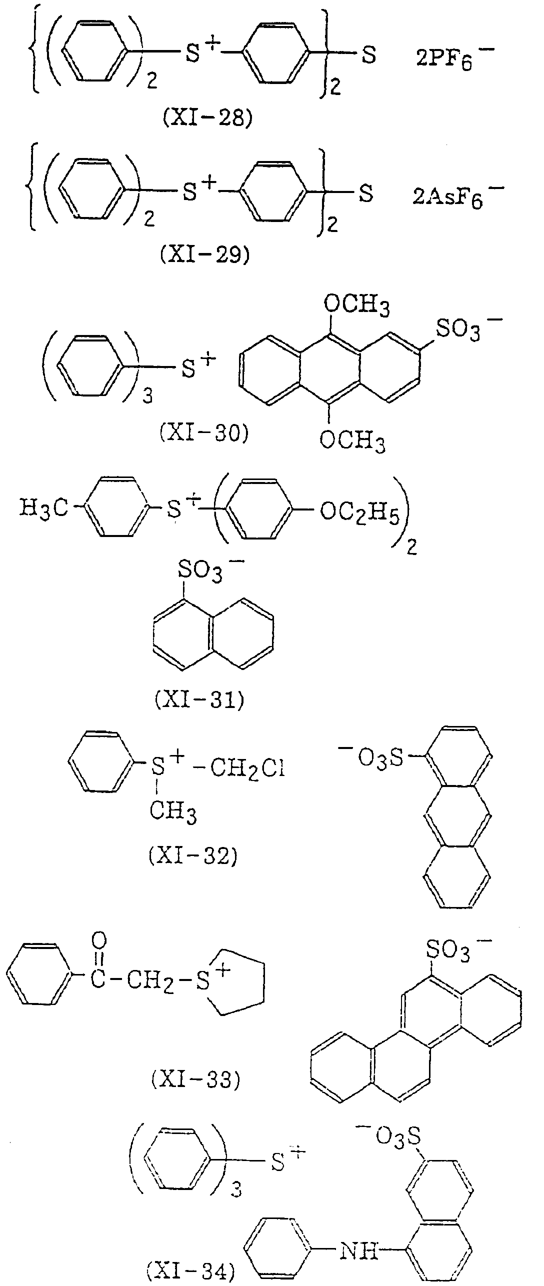
(3) The disulfone derivatives of formula (XII) and the iminosulfonate derivatives of formula (XIII);

   Ar³ - SO₂ - SO₂ - Ar⁴ (XII)

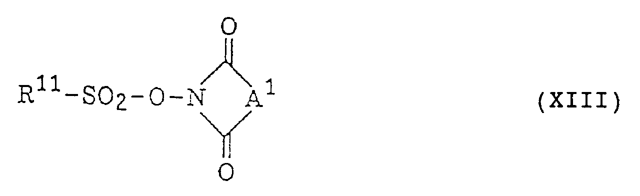

   In the above formulae, Ar³ and Ar⁴ each represent a substituted or unsubstituted aryl group, R¹¹ represents a substituted or unsubstituted alkyl or aryl group, and A¹ represents a substituted or unsubstituted alkylene, alkenylene or arylene group.
   Specific examples of compounds of formulae (XII) and (XIII) include Compounds (XII-1) to (XII-12) and Compounds (XIII-1) to (XIII-12), respectively, illustrated below. However, the foregoing types of derivatives applicable to the invention should not be construed as being limited to the compounds illustrated. 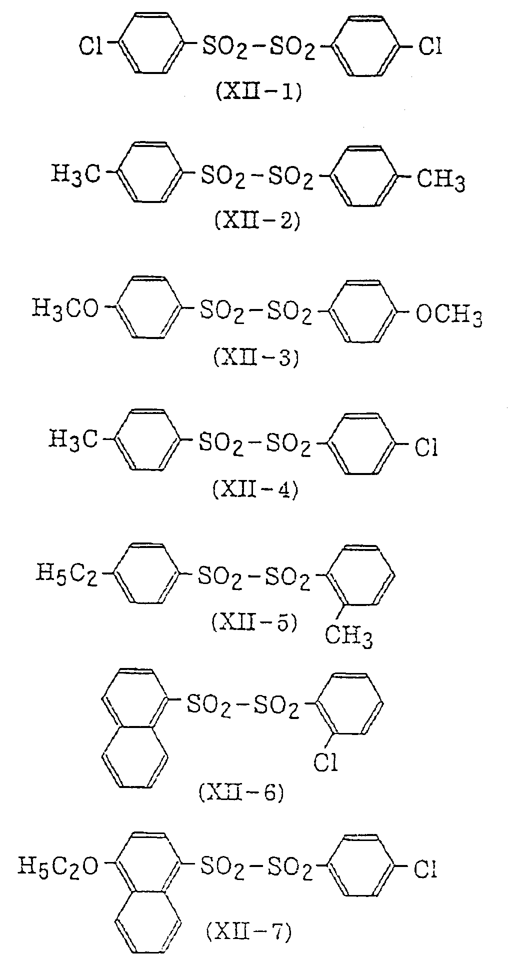 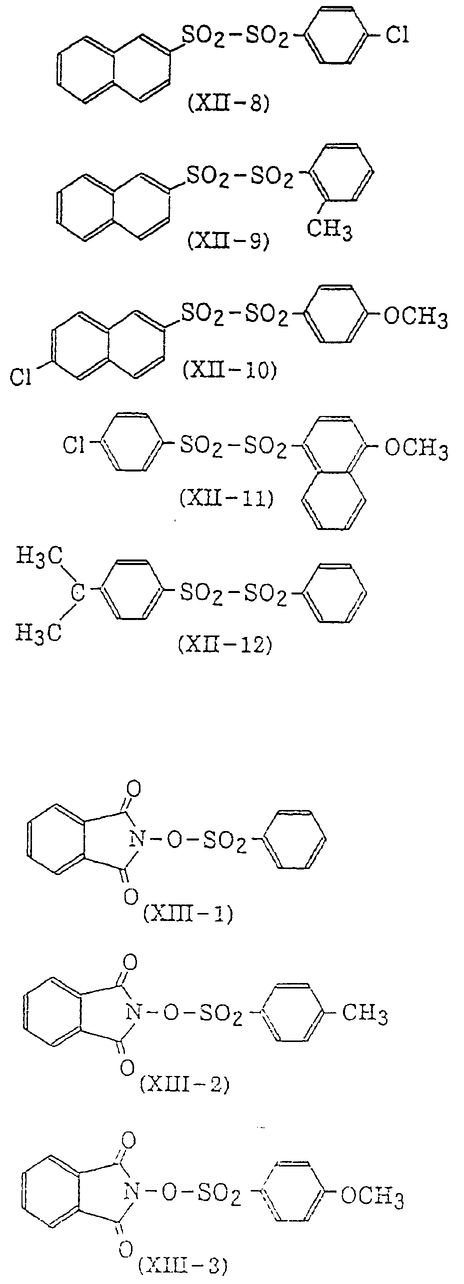 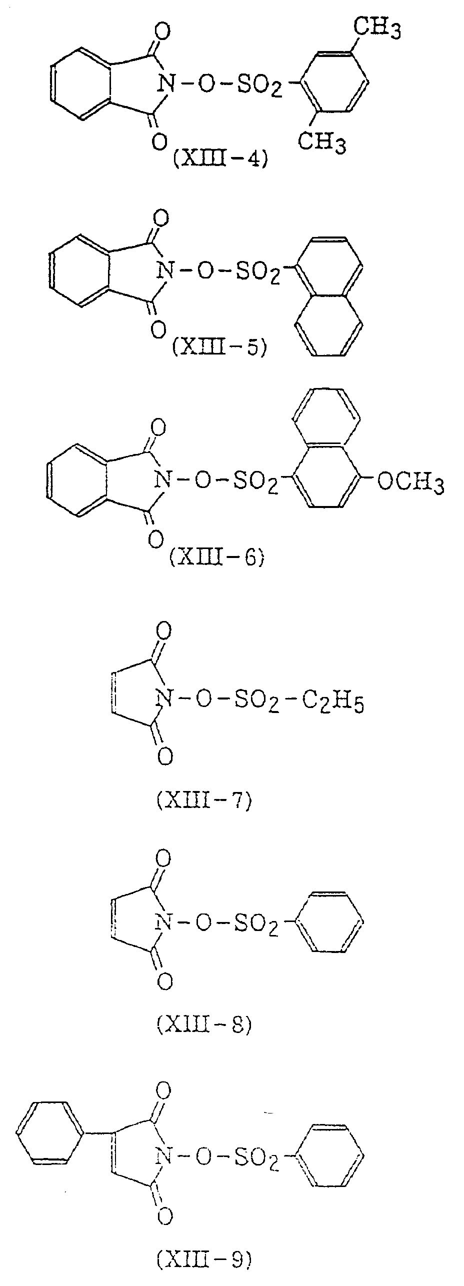 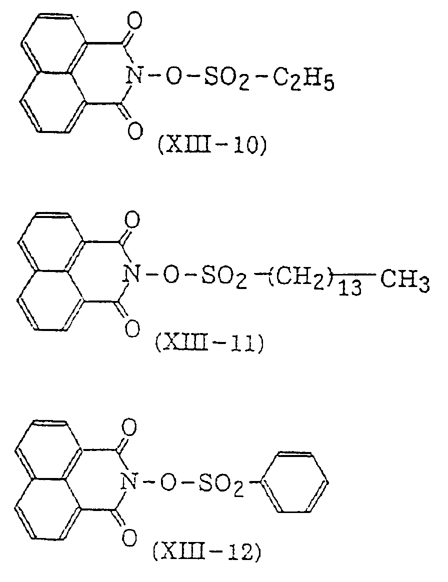
(4) O-Naphthoquinonediazide compounds represented by formula (XIV); 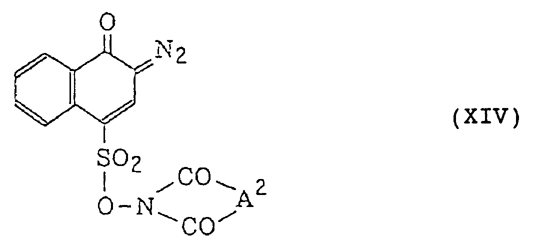 wherein A² represents a substituted or unsubstituted divalent aliphatic or aromatic group. Specific examples of a compound represented by formula (XIV) include Compounds (XIV-1) to (XIV-24), illustrated below. However, the o-naphthoquinone diazide compounds applicable to the invention should not be construed as being limited to the compounds illustrated.

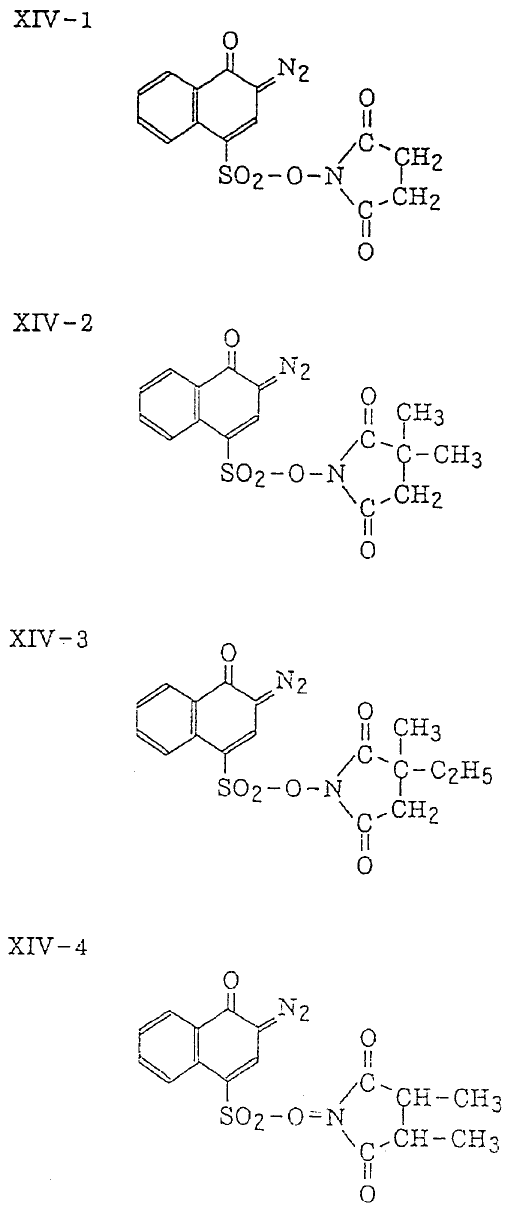

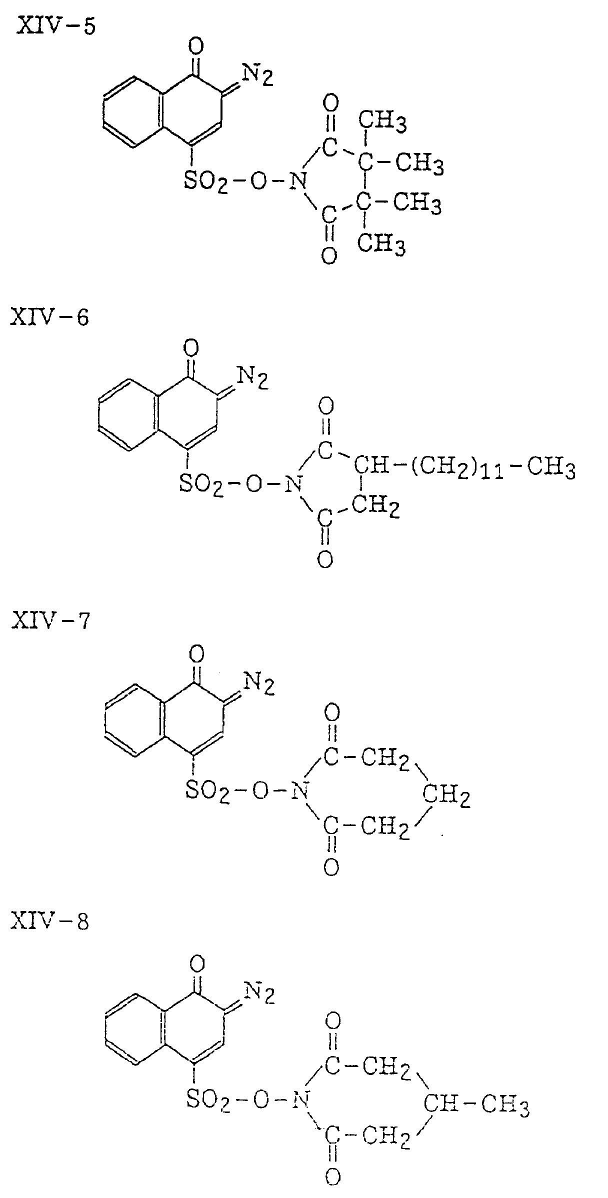

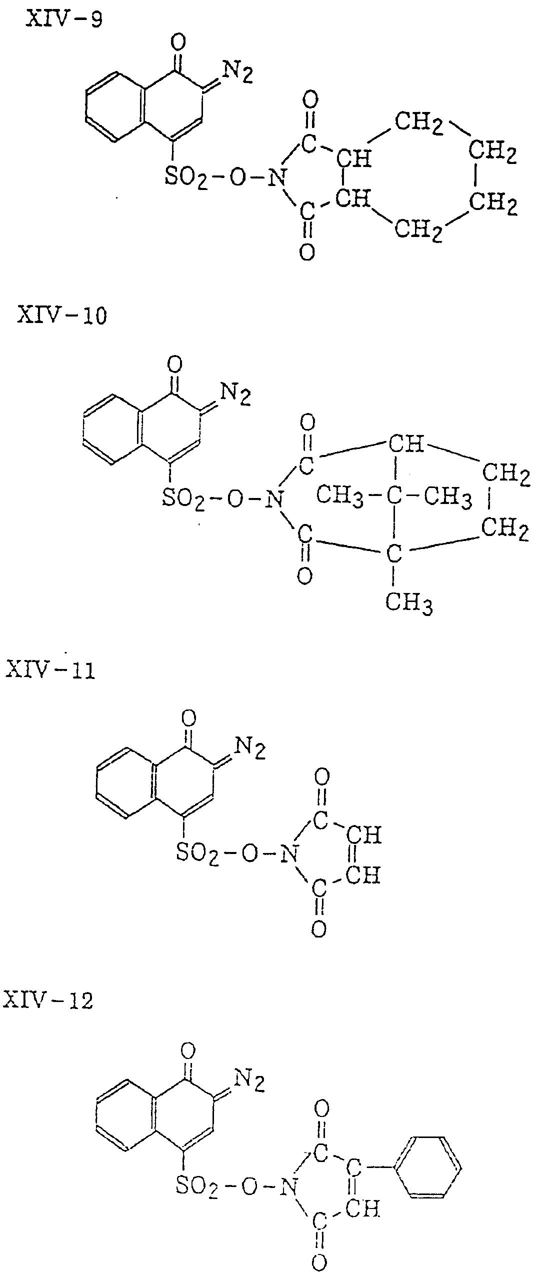

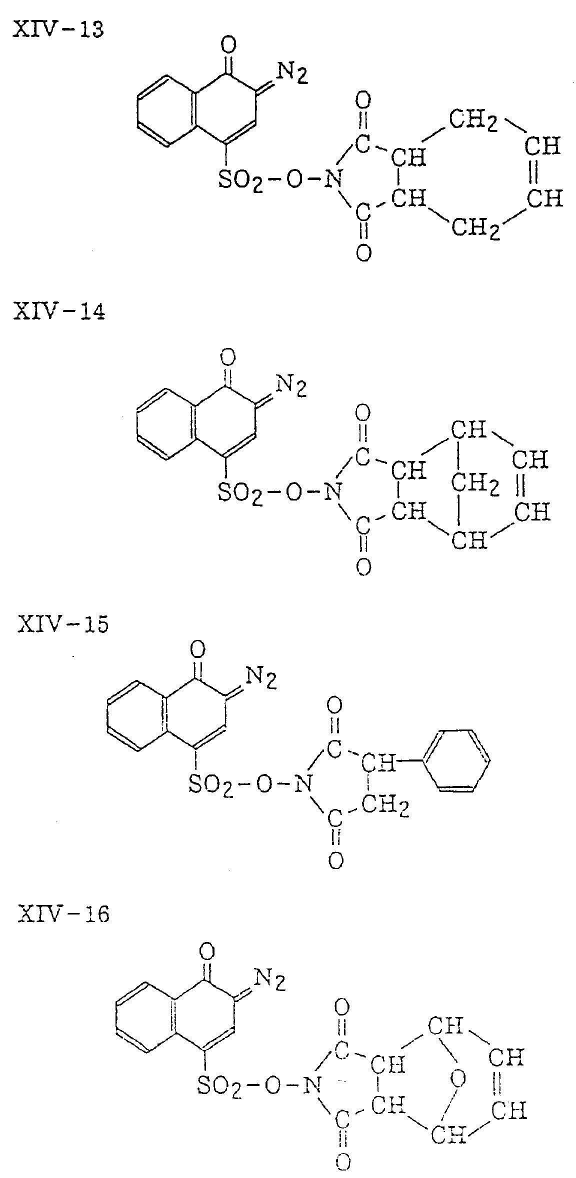

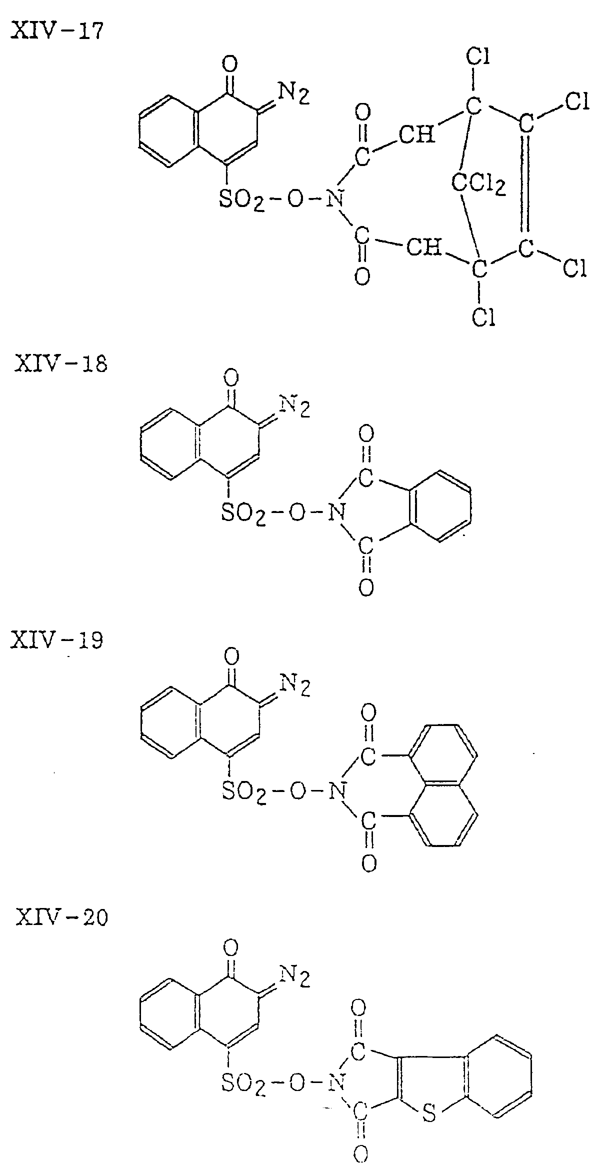

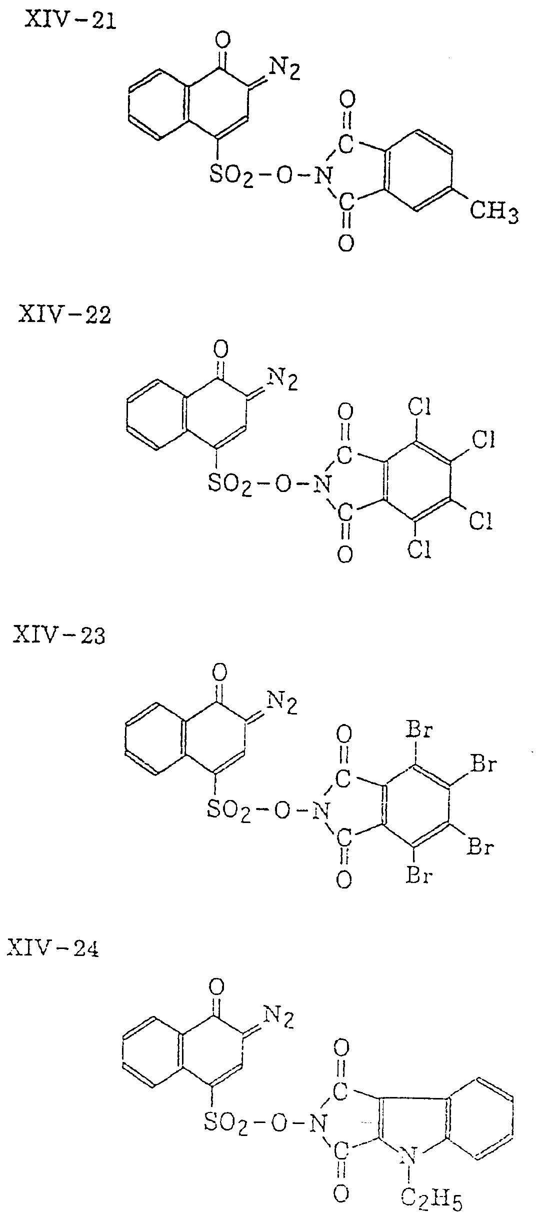

Component (c), which is decomposed by irradiation with active rays or radiation to produce acids, is added in a proportion of generally from 0.001 to 40 % by weight, preferably from 0.1 to 20 % by weight, based on the whole solid content of the photosensitive composition.

To the positive working photosensitive composition of the present invention, there can optionally added compounds capable of improving the photo-acid production efficiency of the above-illustrated acid producing compounds (sensitizers), dyes, pigments, plasticizers and various known compounds usable for adjusting the solubility of a positive working photosensitive composition in an alkaline aqueous solution.

As examples of a sensitizer which can be used, mention may be made of electron donating compounds such as pyrene, perylene and the like, merocyanine dyes and cyanine dyes. However, the sensitizers in the present composition should not be construed as being limited to those compounds. A ratio of those sensitizers to the foregoing component (b) is preferably in the range of 0.01/1 to 20/1 by mole and 0.1/1 to 5/1 by weight.

As described above, dyes can be added as coloring agent to the positive working photosensitive composition of the present invention. Suitable dyes are oil soluble dyes and basic dyes, with specific examples including Oil Yellow #101, Oil Yellow #130, Oil Pink #312, Oil Green BG, Oil Blue BOS, Oil Black BY, Oil Black BS, Oil Black T505 (which all are products of Oriental Chemical Industry Co., Ltd.), Crystal Violet (CI42555), Methyl Violet (CI42535), Rhodamine B (CI45170B), Malachite Green (CI42000), and Methyl Blue (CI52015).

To the photosensitive composition, such dyes can be added generally in a proportion of 0.01 to 10 % by weight, preferably 0.1 to 3 % by weight, based on the whole solid content of the photosensitive composition.

As compounds for adjusting the solubility of the positive working photosensitive composition in an alkaline aqueous solution, cyclic acid anhydrides and fillers can be added.

Examples of the cyclic acid anhydrides include phthalic anhydride, tetrahydrophthalic anhydride, hexahydrophthalic anhydride, 3,6-endoxy-tetrahydrophthalic anhydride, tetrachlorophthalic anhydride, maleic anhydride, chloromaleic anhydride, α-phenylphthalic anhydride, succinic anhydride and pyromellitic acid as described in U.S. Patent 4,115,128. The incorporation of the cyclic acid anhydride in a proportion of preferably 1 to 15 % by weight based on the whole solid content of the photosensitive composition can raise the sensitivity by a factor of about 3 at the greatest. For the purpose of setting up a clear solubility difference between the exposed area and the unexposed area, there can be used the compounds which can be converted to alkali soluble ones by the hydrolysis with an acid, as disclosed, e.g., in JP-A-62-27829, JP-A-63-250642, JP-A-63-139343, JP-A-4-63846, JP-A-4-70021, JP-A-4-67677, JP-A-60-191372, JP-A-48-39003, JP-A-51-120714, JP-A-53-133429, JP-A-55-126236, JP-A-1-106038 and JP-A-64-57258.

The present positive working photosensitive composition is prepared by dissolving in an appropriate solvent the aforementioned components as materials for lithographic printing plate, and applied to a support. Suitable examples of a solvent used herein include ethylene dichloride, cyclohexanone, methyl ethyl ketone, methanol, ethanol, propanol, ethylene glycol monomethyl ether, 1-methoxy-2-propanol, ethylene glycol monoethyl ether, 2-methoxyethylacetate, 1-methoxy-2-propylacetate, dimethoxyethane, methyl lactate, ethyl lactate, N,N-dimethylaceamide, N,N-dimethylformamide, tetramethylurea, N-methylpyrrolidone, dimethyl sulfoxide, sulforan, γ-butyrolactam, toluene, ethyl acetate, and dioxane. These solvents may be used alone or as a mixture.

The concentration of the foregoing components (the whole solid content, including additives) in a solvent is preferably in the range of 2 to 50 % by weight. In coating a support with the present composition, the coverage rate of the composition, though it depends on the end use purpose of the composition, is generally in the range of 0.5 to 3.0 g/m², on a solid content basis. While the sensitivity is increased with a decrease in coverage rate, the film characteristics of the coating of the sensitive composition are deteriorated therewith.

As a support for the lithographic printing plate of the present invention, there is used an aluminum support previously treated with a silicate to be rendered hydrophilic. An aluminum plate is preferred in particular because it has very high dimensional stability and the price thereof is low. Also, a composite sheet formed by uniting a polyethylene terephthalate film and an aluminum sheet as disclosed in JP-B-48-18327 is favored. It is desirable to form a passive-state sturdy film on the surface of an aluminum plate by subjecting the plate to a graining treatment using a mechanical method, such as a wire brush graining method, a brush graining method in which the plate surface is roughened with a nylon brush as a slurry of abrasive particles is applied thereonto, a ball graining method, a method of graining by means of liquid horning, a buff graining method, etc., a chemical graining method using HF, AlCl₃ or HCl as an etchant, an electrolytic graining method using nitric acid or hydrochloric acid as an electrolytic solution, or a combined graining method using two or more of the above-cited surface roughening methods in combination, and then etching the grained plate with an acid or alkali, if needed, and subsequently oxidizing the resulting plate anodically in sulfuric acid, phosphoric acid, chromic acid, sulfaminic acid or a mixture of two or more thereof by means of a DC or AC equipment.

For the aluminum plate which have undergone the graining and subsequent anodic oxidation treatments, it is preferable to be further subjected to a sealing treatment. The sealing treatment is effected by dipping the aluminum plate in hot water or a hot aqueous solution containing an inorganic or organic salt, or by steam bathing.

Although the thus formed passive-state film itself can render the aluminum plate surface hydrophilic, a silicate treatment is further carried out in order to prepare the hydrophilic aluminum support used in the present invention. As a suitable example of such a treatment, mention may be made of the electrodeposition of a silicate as disclosed in U.S. Patent 3,658,662.

The aluminum support thus prepared is coated with the positive working photosensitive composition of the present invention according to a known coating technique. As for the coating technique which can be used herein, a spin coating method, a wire bar coating method, a dip coating method, an air knife coating method, a roll coating method, a blade coating method, a curtain coating method and a spray coating method are examples thereof.

The thus formed layer of the positive working photosensitive composition is dried for 0.5 to 10 minutes at 40-150°C by means of a hot-air dryer or infrared dryer. In order to cross-link the component (a) with the component (b), a way of heating them, e.g., during or after the coating and drying operation of the photosensitive composition can be adopted. The heating operation for cross-linking is carried out preferably at a temperature of 60-150°C, more preferably 80-130°C, for a period of preferably from 5 seconds to 20 minutes, more preferably from 20 seconds to 5 minutes.

The positive working printing plate composition of the present invention is generally subjected to imagewise exposure and development.

Suitable examples of a light source of active rays used for the imagewise exposure include a mercury lamp, a metal halide lamp, a xenon lamp, a chemical lamp and a carbon arc lamp. As for the radiation, electron beams, X-rays, ion beams and far ultraviolet rays. As a light source for photoresists, g-ray, i-ray and Deep UV light are preferably used. Also, scanning exposure using high density energy beams (laser beams or electron beams) can be applied to the present invention. Examples of the laser beam include He-Ne laser, Ar laser, krypton ion laser, He-Cd laser and KrF excimer laser.

Examples of a developer suitable for the development of the present positive working printing plate include an aqueous solution of an inorganic alkali agent such as sodium silicate, potassium silicate, sodium hydroxide, potassium hydroxide, lithium hydroxide, sodium tertiary phosphate, sodium secondary phosphate, ammonium tertiary phosphate, ammonium secondary phosphate, sodium metasilicate, sodium hydrogen carbonate, aqueous ammonia, etc., and an aqueous solution of an organic alkali agent such as tetraalkylammonium halides. Such an alkali agent is added to water so as to have a concentration of generally from 0.1 to 10 % by weight, preferably from 0.5 to 5 % by weight.

To such an alkaline aqueous solution, a surfactant and an organic solvent such as an alcohol can also be added, if desired.

The present invention will now be illustrated in more detail by reference to the following examples. However, the invention should not be construed as being limited to these examples.

### EXAMPLES 1 TO 17 AND COMPARATIVE EXAMPLES 1 TO 4

A 0.24 mm-thick IS aluminum plate was degreased by 3 minutes's soaking in a 10 wt% aqueous solution of sodium tertiary phosphate kept at 80°C, grained with a nylon brush, etched for about 10 minutes with sodium aluminate, and then dismatted with a 3 wt% aqueous solution of sodium hydrogen sulfate. The thus treated aluminum plate was subjected to 2 minutes' anodic oxidation under a current density of 2 A/dm² in 20 wt% sulfuric acid. Thereafter, the anodically oxidized plate was rendered more hydrophilic by undergoing a silicate electrodeposition treatment.

Twenty three types of photosensitive compositions, from (A)-1 to (A)-17 and from (A')-1 to (A')-6, were prepared using various linear high polymers, various vinyl ether compounds and various photo-acid generators in combination, as set forth in Table 1, respectively in accordance with the formula described below. These photosensitive compositions were each applied to the aluminum plate which had undergone the aforementioned treatments, and dried at 100°C for 10 minutes, thereby forming presensitized plates. The coverage rate of every photosensitive composition was adjusted to 1.7 g/m² on a dry basis.

| Formula of Photosensitive Composition (A): | |
|---|---|
| Linear high polymer as set forth in Table 1 | 2.0 g |
| Vinyl ether compound as set forth in Table 1 | 0.4 g |
| Photo-acid generator as set forth in Table 1 | 0.1 g |
| Dioxane | 50.0 g |
| Methanol | 15.0 g |

**Table 1**

| | Photosensitive Composition | Linear High Polymer | Vinyl Ether Compound | Photo-acid Generator |
|---|---|---|---|---|
| Example 1 | (A)-1 | P-1 | II-11 | X-21 |
| Example 2 | (A)-2 | P-2 | II-11 | X-21 |
| Example 3 | (A)-3 | P-3 | II-11 | X-21 |
| Example 4 | (A)-4 | P-4 | II-11 | X-21 |
| Example 5 | (A)-5 | P-5 | II-11 | X-21 |
| Example 6 | (A)-6 | P-6 | II-11 | X-21 |
| Example 7 | (A)-7 | P-7 | II-11 | X-21 |
| Example 8 | (A)-8 | P-1 | II-1 | X-21 |
| Example 9 | (A)-9 | P-1 | II-35 | X-21 |
| Example 10 | (A)-10 | P-1 | VII-5 | X-21 |
| Example 11 | (A)-11 | P-1 | II-11 | XII-11 |
| Example 12 | (A)-12 | P-1 | II-11 | XIV-14 |
| Example 13 | (A)-13 | P-2 | II-5 | XIV-10 |
| Example 14 | (A)-14 | P-3 | II-9 | XIV-12 |
| Example 15 | (A)-15 | P-4 | II-12 | XIV-14 |
| Example 16 | (A)-16 | P-5 | II-13 | XII-11 |
| Example 17 | (A)-17 | P-6 | VII-11 | XII-11 |
| Comparative Example 1 | (A')-1 | P-1 | II-11 | - |
| Comparative Example 2 | (A')-2 | P-1 | - | X-21 |
| Comparative Example 3 | (A')-3 | P'-1 | II-11 | X-21 |
| Comparative Example 4 | (A')-4 | P'-2 | II-11 | X-21 |
| Comparative Example 5 | (A')-5 | P'-3 | II-11 | X-21 |
| Comparative Example 6 | (A')-6 | P'-4 | II-11 | X-21 |

As for the linear high polymers set forth in Table 1, those symbolized by from P-1 to P-7 are illustrated hereinbefore, and those symbolized by from P'-1 to P'-4 are as follows;
P'-1: 2-Hydroxyethyl methacrylate/benzyl methacrylate (20/80, by wt%) copolymer, Molecular weight Mw = 4.3×10⁴.
P'-2: Methacrylic acid/benzyl methacrylate (20/80, by mole%) copolymer, Molecular weight Mw = 3.4×10⁴.
P'-3: Methacrylic acid/benzyl methacrylate/2-hydroxyethyl methacrylate (10/50/40, by mole%) copolymer, Molecular weight Mw = 3.2×10⁴.
P'-4: Methacrylic acid/benzyl methacrylate/2-hydroxyethyl methacrylate (40/50/10, by mole%) copolymer, Molecular weight Mw = 3.5×10⁴.

In order to ascertain to what extent the foregoing photosensitive layers of the presensitized plates were each cross-linked by the heat applied upon drying them, each of the presensitized plates was soaked for 5 minutes in each of the solvents set forth in Table 2, and then rinsed, followed by observation of a state of dissolution of each photosensitive layer. The observation results are shown in Table 2. Therein, the capital letter "A" means that a photosensitive layer is free from dissolution, the capital letter "B" means that a photosensitive layer is partly dissolved (namely, it causes a decrease in thickness), and the capital letter "C" means that a photosensitive layer is mostly dissolved. Additionally, the capital letter "Y" represents an undiluted developer, and the expression Y/Water (1/2) means a solution obtained by diluting the developer Y with twice the quantity of water.

**Table 2**

| Solubility of Photosensitive Layer | | | | |
|---|---|---|---|---|
| | Y/Water (1/2) | Methyl Ethyl Ketone | Dioxane | Toluene |
| Example 1 | A | A | A | A |
| Example 2 | A | A | A | A |
| Example 3 | A | A | A | A |
| Example 4 | A | A | A | A |
| Example 5 | A | A | A | A |
| Example 6 | A | A | A | A |
| Example 7 | A | A | A | A |
| Example 8 | A | A | A | A |
| Example 9 | A | A | A | A |
| Example 10 | A | A | A | A |
| Example 11 | A | A | A | A |
| Example 12 | A | A | A | A |
| Example 13 | A | A | A | A |
| Example 14 | A | A | A | A |
| Example 15 | A | A | A | A |
| Example 16 | A | A | A | A |
| Example 17 | A | A | A | A |
| Comparative Example 1 | A | A | A | A |
| Comparative Example 2 | C | C | C | C |
| Comparative Example 3 | A | C | C | B |
| Comparative Example 4 | B | A | A | A |
| Comparative Example 5 | A | A | A | A |
| Comparative Example 6 | C (loosening layer) | A | A | A |

As shown in Table 2, all the photosensitive layers according to the present invention were insoluble in all the solvents, while the photosensitive layers prepared in Comparative Examples 2-4 and 6 were partly or, what is worse, completely dissolved in some of the solvents. Thus, it was confirmed that the photosensitive layer made from the present printing plate composition had satisfactory cross-linking properties.

In the next place, a gray scale having a density difference of 0.15 was brought into contact with the photosensitive layer of each of the presensitized plate prepared above, and exposed for 20 seconds by means of a 2 KW high-pressure mercury lamp placed at a distance of 50 cm. The exposed presensitized plates were each heated at 120°C for 5 minutes, and then developed by dipping in an aqueous solution, prepared by diluting the undiluted developer Y having the following composition with twice the quantity of water, at 25°C for 60 seconds. The thus obtained images were evaluated by visual observation. The results obtained are shown in Table 3.

| Composition of Developer Y: | |
|---|---|
| Water | 80 g |
| Triethanol amine | 3 g |
| Sodium t-butylnaphthalenesulfonate | 8 g |
| Benzyl alcohol | 9 g |

As shown in Table 3, all the presensitized plates of Examples according to the present invention provided clear positive images. On the other hand, with respect to the presensitized plate of Comparative Example 1 not containing a photo-acid generator, both exposed and unexposed areas were not dissolved at all to provide no image, and with respect to the presensitized plate of Comparative Example 2 not containing a vinyl ether compound, both exposed and unexposed areas were completely dissolved to provide no image.

With respect to each of the presensitized plates of Comparative Examples 3 and 4 comprising liner high polymers prepared by not using an acid group-containing monomer and a hydroxyl group-containing monomer, respectively, the photosensitive layer was reduced in thickness to result in formation of no image in Comparative Example 3 and unclear image in Comparative Example 4.

In Comparative Example 5 using a comparative linear high polymer whose hydroxyl group-containing monomer content was higher than the upper limit of the present invention, a clear positive image was obtained, while in Comparative Example 6 using a comparative linear high polymer whose acid group-containing monomer content was higher than the upper limit of the present invention, reduction in thickness of the photosensitive layer was caused to result in formation of unclear image.

Further, each of the images obtained was examined for clear step number of the gray scale by visual observation. The results thereof are also shown in Table 3. As can be seen from Table 3, clear step numbers attained were high in all the presensitized plates made in Examples according to the present invention. In other words, all the presensitized plates according to the present invention proved to have high sensitivity. In every Comparative Example except Comparative Example 5, on the other hand, no image was obtained or a clear step number obtained was considerably low.

Furthermore, each of the printing plates obtained above was coated with a gum solution (GU-7, trade name, a product of Fuji Photo Film Co., Ltd.), and then subjected to a printing operation using a printer, HALLYS ALLELYA 125, thereby obtaining printed matter. At the time when a printing of 100 copies was performed, the 100th copy was examined for scumming. The extent of scumming was evaluated by visually observing the non-image area. The observation results are shown in Table 3, using the mark A" to represent the generation of no scumming, the mark "B" to represent the generation of slight scumming and the mark "C" to represent the generation of distinct scumming.

**Table 3**

| | Image Performance | Clear Step Number of Gray Scale | Scumming |
|---|---|---|---|
| Example 1 | Clear positive image | 10 | A |
| Example 2 | Clear positive image | 9 | A |
| Example 3 | Clear positive image | 10 | A |
| Example 4 | Clear positive image | 11 | A |
| Example 5 | Clear positive image | 10 | A |
| Example 6 | Clear positive image | 7 | A |
| Example 7 | Clear positive image | 8 | A |
| Example 8 | Clear positive image | 9 | A |
| Example 9 | Clear positive image | 10 | A |
| Example 10 | Clear positive image | 11 | A |
| Example 11 | Clear positive image | 10 | A |
| Example 12 | Clear positive image | 11 | A |
| Example 13 | Clear positive image | 10 | A |
| Example 14 | Clear positive image | 9 | A |
| Example 15 | Clear positive image | 8 | A |
| Example 16 | Clear positive image | 7 | A |
| Example 17 | Clear positive image | 8 | A |
| Comparative Example 1 | Not dissolved in both unexposed and exposed areas | | - |
| Comparative Example 2 | Dissolved in both unexposed and exposed areas | | - |
| Comparative Example 3 | Reduced in thickness of both unexposed and exposed area (no image) | | - |
| Comparative Example 4 | Positive image (reduction in thickness of the photosensitive layer | 4 | B |
| Comparative Example 5 | Clear positive image | 8 | C |
| Comparative Example 6 | Positive image (reduction in thickness of the photosensitive layer | 4 | - |

As shown in Table 3, all the printing plates according to the present invention caused no scumming. However, distinct scumming was caused by the printing plate made of the presensitized plate obtained in Comparative Example 5, although the presensitized plate itself formed a clear positive image.

Thus, it turned out that the positive working printing plate composition relating to the present invention had high sensitivity, provided a clear positive image and caused no scumming when the linear high polymer used therein were constituted of specified proportions of monomer units.

### EXAMPLES 18

A gray scale having a density difference of 0.15 was brought into contact with the photosensitive layer of the presensitized plate obtained in Example 1, and exposed for 20 seconds by means of a 2 KW high-pressure mercury lamp placed at a distance of 50 cm. The exposed presensitized plate was heated at 120°C for 5 minutes, and then developed with an aqueous solution prepared by diluting a developer, Y-3C (trade name, a product of Fuji Photo Film Co., Ltd.), with twice the quantity of water at 25°C for a period of time set variously, namely at 20 seconds, 30 seconds, 1 minute, 2 minutes, 5 minutes or 10 minutes. In every development operation, a positive image of good quality was obtained, the clear step number of gray scale was 13, and high sensitivity was attained.

All the results described above demonstrate that a positive working printing plate composition according to the present invention has high sensitivity, provides a clear positive image, causes no scumming and has a wide development latitude.

In accordance with the present invention, there can be provided a positive working printing plate which does not cause scumming, particularly after a lapse of time, has high photosensitivity, and enables the use of rays in a wide wavelength range as light source. Further, a positive working printing plate composition which has a large solubility difference between unexposed and exposed areas and a wide development latitude can be provided.

While the invention has been described in detail with reference to specific embodiments, it will be apparent to one skilled in the art that various changes and modifications can be made to the invention without departing from its spirit and scope.

## Claims

1. A positive working printing plate comprising an aluminum support having hydrophilicity acquired by a silicate treatment and having provided thereon a positive working photosensitive composition containing at least (a) a compound having at least two enol ether groups represented by formula (I), (b) a linear high polymer containing acid groups and hydroxy groups, and (c) a compound capable of producing an acid by being decomposed upon irradiation with active rays or radiation,
wherein component (a) and component (b) are cross-linked by applied heat,
component (b) is a copolymer constituted of monomers containing acid group(s), monomers containing hydroxy group(s) and monomers containing neither acid nor hydroxy group or a copolymer constituted of monomers containing both acid and hydroxy groups and monomers containing neither acid nor hydroxy group, and
the ratio of the monomers containing acid group(s) to the monomers containing hydroxy group(s) to the monomers containing neither acid nor hydroxy group is in the range of (5-30)/(5-30)/(90-40) by mole or the ratio of the monomers containing both acid and hydroxy groups to the monomers containing neither acid nor hydroxy group is in the range of (5-30)/(95-70) by mole:
(R²)(R¹)C = C(R³)―O― (I)
wherein R¹, R² and R³ are the same or different, and each represents a hydrogen atom, an alkyl group or an aryl group, and two of them may combine to form a saturated or olefinically unsaturated ring.

2. The positive working printing plate of claim 1, wherein R¹, R² and R³ each independently represents a hydrogen atom, a saturated or unsaturated, straight-chain, branched or alicyclic, alkyl group having 1 to 20 carbon atoms which may be substituted with a halogen atom, a cyano group, an ester group, a hydroxy group, an alkoxy group, an aryloxy group or an aryl group, and an aryl group containing 6 to 20 carbon atoms which may be substituted with an alkyl group, an alkoxy group, an aryloxy group, an acyl group, an acyloxy group, an alkylmercapto group, an aminoacyl group, a carboalkoxy group, a nitro group, a sulfonyl group, a cyano group or a halogen atom.

3. The positive working printing plate of claim 1, wherein component (a) is represented by formula (II) or (III):
A - (-O-(R⁴-O)ₙ-CH=CH₂)ₘ (II)
A - (-B-R⁴-O-CH=CH₂)ₘ (III)
wherein A represents a m-valent alkyl, aryl or heterocyclic group, B represents -COO-, -NHCOO- or -NHCONH-, R⁴ represents a straight-chain or branched alkylene group containing 1 to 10 carbon atoms, n represents 0 or an integer of 1 to 10, and m represents an integer of 2 to 6.

4. The positive working printing plate of claim 1, wherein the ratio of the monomers containing acid group(s) to the monomers containing hydroxy group(s) to the monomers containing neither acid nor hydroxy group is in the range of (5-25)/(5-25)/(90-50) by mole, or the ratio of the monomers containing both acid and hydroxy groups to the monomers containing neither acid nor hydroxy group is in the range of (5-25)/(95-75) by mole.

5. The positive working printing plate of claim 1, wherein component (a) is incorporated in an amount of 1 to 80 % by weight based on the solid content of the composition.

6. The positive working printing plate of claim 1, wherein component (a) is incorporated in an amount of 5 to 50 % by weight based on the solid content of the composition.

7. The positive working printing plate of claim 1, wherein component (b) is incorporated in an amount of 1 to 95 % by weight based on the solid content of the composition.

8. The positive working printing plate of claim 1, wherein component (b) is incorporated in an amount of 20 to 90 % by weight based on the solid content of the composition.
